(19) **Europäisches Patentamt / European Patent Office / Office européen des brevets**

(11) **EP 4 604 112 A1**

(12) **EUROPEAN PATENT APPLICATION**
published in accordance with Art. 153(4) EPC

(43) Date of publication:
**20.08.2025 Bulletin 2025/34**

(21) Application number: **23877425.1**

(22) Date of filing: **27.06.2023**

(51) International Patent Classification (IPC):
*G09G 3/3233* (2016.01)   *H10K 59/121* (2023.01)
*H10K 59/131* (2023.01)   *H10K 59/80* (2023.01)
*G09G 3/20* (2006.01)

(52) Cooperative Patent Classification (CPC):
**H10K 59/1213; H10K 59/131**

(86) International application number:
**PCT/KR2023/008892**

(87) International publication number:
**WO 2024/080494 (18.04.2024 Gazette 2024/16)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **11.10.2022 KR 20220130097**
**19.01.2023 KR 20230008362**

(71) Applicant: **Samsung Display Co., Ltd.**
**Yongin-si, Gyeonggi-do 17113 (KR)**

(72) Inventors:
• **KIM, Han Bit**
**Yongin-Si Gyeonggi-do 17113 (KR)**

• **KIM, Keun Woo**
**Yongin-Si Gyeonggi-do 17113 (KR)**
• **KIM, Doo Na**
**Yongin-si Gyeonggi-do 17113 (KR)**
• **KIM, Sang Sub**
**Yongin-si Gyeonggi-do 17113 (KR)**
• **SEOL, Chan Yeob**
**Yongin-si Gyeonggi-do 17113 (KR)**
• **CHU, Jae Hwan**
**Yongin-si Gyeonggi-do 17113 (KR)**
• **CHOI, Sang Gun**
**Yongin-si Gyeonggi-do 17113 (KR)**

(74) Representative: **Marks & Clerk LLP**
**15 Fetter Lane**
**London EC4A 1BW (GB)**

(54) **DISPLAY DEVICE**

(57)   A display device including a pixel electrode, and a pixel circuit electrically connected to the pixel electrode. The pixel circuit includes a first transistor including sub-transistors electrically connected to each other through a first common node, a second transistor including sub-transistors electrically connected to each other through a second common node, a first electrode electrically connecting the first common node with the second common node, and a second electrode disposed to overlap the first electrode and electrically connected to a direct current power source.

**EP 4 604 112 A1**

Fig. 17

111, 333

## Description

[TECHNICAL FIELD]

The disclosure relates to a display device that may minimize flicker even in the case of low frequency driving.

[BACKGROUND TECHNOLOGY]

An organic light emitting display device includes a display element, of which luminance is changed by a current, for example, an organic light emitting diode.

The organic light emitting display device includes a plurality of pixels that may provide light of different colors.

[DETAILS OF THE INVENTION]

An aspect of the disclosure is to provide a display device that may minimize flicker even during low frequency driving.

Aspects of the disclosure are not limited to those mentioned above and additional aspects of the disclosure, which are not mentioned herein, will be clearly understood by those skilled in the art from the following description of the disclosure.

[TECHNICAL SOLUTION]

According to an embodiment of the disclosure, a display device includes a pixel electrode(PE1), and a pixel circuit(PC1) electrically connected to the pixel electrode. The pixel circuit may include a first transistor(T3) including a plurality of sub-transistors(T3-1, T3-2) electrically connected to each other through a first common node(CN1), a second transistor(T4) including a plurality of sub-transistors(T4-1, T3-4) electrically connected to each other through a second common node(CN2), a first electrode(C3a) electrically connecting the first common node with the second common node, and a second electrode(C3b) disposed to overlap the first electrode and electrically connected to a direct current power source.

In an embodiment, the first common node, the second common node, and the first electrode are integral with each other.

In an embodiment, a first sub-transistor(T3-1) of the first transistor and a second sub-transistor(T4-1) of the second transistor are electrically connected to each other through source electrodes and drain electrodes of the first sub-transistor of the first transistor and the second sub-transistor of the second transistor, and the source electrode of the first sub-transistor, the drain electrode of the first sub-transistor, the first common node, the first electrode, the second common node, the source electrode of the second sub-transistor, and the drain electrode of the second sub-transistor are electrically connected to one another and form a closed loop shape.

In an embodiment, the source electrode of the first sub-transistor, the drain electrode of the first sub-transistor, the first common node, the first electrode, the second common node, the source electrode of the second sub-transistor, and the drain electrode of the second sub-transistor have a closed loop shape surrounding at least a portion of a gate electrode(GE3-1) of the first sub-transistor.

In an embodiment, the first common node, the second common node, and the first electrode are formed of a semiconductor material.

In an embodiment, the second electrode overlaps the entirety of the first electrode.

In an embodiment, an area of the second electrode is wider than an area of the first electrode. In an embodiment, the first electrode and the second electrode have a same shape.

In an embodiment, the first electrode includes a first extension portion(EX1) extended from the first common node(CN1) in a second direction(DR2) intersecting a first direction(DR1), a second extension portion(EX2) extended from the second common node(CN2) in the first direction, and a connection portion electrically connecting the first extension portion with the second extension portion.

In an embodiment, the connection portion includes at least one curved portion.

In an embodiment, a first sub-transistor of the first transistor and a second sub-transistor of the second transistor are electrically connected to each other through a source electrode and a drain electrode of the second sub-transistor, and the source electrode of the first sub-transistor, the drain electrode of the first sub-transistor, the first common node, the first extension portion, the connection portion, the second extension portion, the second common node, the source electrode of the second sub-transistor, and the drain electrode of the second sub-transistor are electrically connected to one another and form a closed loop shape.

In an embodiment, the display device further comprises a direct current power line(DCL) electrically connecting the direct current power source with the second electrode.

In an embodiment, the display device may further include a first driving voltage line(VDL), a first initialization voltage line(VIL1), a second initialization voltage line(VIL2), and a bias voltage line(VBL) which are electrically connected to the pixel circuit.

In an embodiment, the direct current power line is one of the first driving voltage line, the first initialization voltage line, the second initialization voltage line, and the bias voltage line.

In an embodiment, the direct current power line is the first driving voltage line, and the second electrode and the direct current power line are integral with each other.

In an embodiment, the direct current power line may is one of the first initialization voltage line, the second initialization voltage line, and the bias voltage line.

In an embodiment, the second electrode and the first driving voltage line are separated from each other.

In an embodiment, the display device further includes a connection electrode(CCE) electrically connecting the direct current power line with the second electrode.

In an embodiment, the connection electrode is disposed on a different layer from the direct current power line and the second electrode.

In an embodiment, the display device further includes a data line(DL3) disposed to be adjacent to the first electrode. The connection electrode is disposed between the data line and a first upper driving voltage line(VDLc) of the first driving voltage line.

In an embodiment, the connection electrode, the data line, and the first upper driving voltage line are disposed on a same layer.

In an embodiment, the pixel circuit further includes a driving transistor(T1) electrically connected between the first driving voltage line and the pixel electrode, and a first capacitor electrically connected between the first driving voltage line and a gate electrode of the driving transistor.

In an embodiment, a first sub-transistor(T3-1) of the first transistor and a second sub-transistor(T4-1) of the second transistor are electrically connected to each other through source electrodes and drain electrodes of the first sub-transistor of the first transistor and the second sub-transistor of the second transistor, and a contact point of the first sub-transistor and the second sub-transistor are electrically connected to the gate electrode of the driving transistor.

In an embodiment, gate electrodes of the plurality of sub-transistors included in the first transistor are integral with each other, and gate electrodes of the plurality of sub-transistors included in the second transistor may be integral with each other.

In an embodiment, a capacitor(C3) is disposed in an overlap area between the first electrode and the second electrode.

According to an embodiment of the disclosure, a display device includes a pixel electrode, a plurality of composite gate transistors(T3, T4) electrically connected to the pixel electrode, a first electrode(C3a) electrically connecting common nodes(CN2, CN2) of at least two composite gate transistors to each other, and a second electrode(C3b) disposed to overlap the first electrode and electrically connected to a direct current power source.

In an embodiment, each of the composite gate transistors includes a plurality of sub-transistors electrically connected to a corresponding common node of a corresponding composite gate transistor.

In an embodiment, the common nodes of the plurality of composite gate transistors and the first electrode are integral with each other.

Specific details of other embodiments are included in the detailed description and drawings.

[EFFECT OF INVENTION]

In the display device according to the disclosure, a first electrode (e.g., third lower capacitor electrode) of a third capacitor may have a structure for connecting a first common node with a second common node of dual gate transistors and thus may have a wide area as much as a connection path between the first common node and the second common node, so that a capacity of the third capacitor may be increased. Therefore, a kickback voltage of the dual gate transistor may be reduced, whereby an off-leakage current of the dual gate transistor may be reduced.

As the off-leakage current of the dual gate transistor is reduced, low frequency flicker may be improved, so that the display device may be driven without flicker even at a lower frequency.

Moreover, since the first electrode of the third capacitor may have a wide area, light from a lower portion of a substrate may be more effectively shielded.

Meanwhile, the effects obtainable from the present invention are not limited to the effects mentioned above, and other effects not mentioned can be clearly understood by a person having ordinary skill in the technical field to which the present invention belongs from the description below.

[BRIEF DESCRIPTION OF THE DRAWINGS]

FIG. 1 is a schematic perspective view illustrating a display device according to an embodiment;
FIG. 2 is a schematic block view illustrating a display panel and a display driver according to an embodiment;
FIG. 3 is a schematic plan view illustrating a display unit of a display device according to an embodiment;
FIG. 4 is a schematic block view illustrating a display panel and a display driver according to an embodiment;
FIG. 5 is a schematic circuit view illustrating a pixel of a display device according to an embodiment;
FIG. 6A is a schematic plan view illustrating a pixel array of a display device according to an embodiment of the disclosure, which includes a pixel circuit of FIG. 5;
FIG. 6B is a schematic plan view illustrating that pixel electrodes and light emission areas are removed from FIG. 6A;
FIG. 7 is a schematic plan view selectively illustrating only a first conductive layer of elements of FIG. 6A;
FIG. 8 is a schematic plan view selectively illustrating only a second conductive layer of elements of FIG. 6A;

FIG. 9 is a schematic plan view selectively illustrating only a third conductive layer of elements of FIG. 6A;

FIG. 10 is a schematic plan view selectively illustrating only a fourth conductive layer of elements of FIG. 6A;

FIG. 11 is a schematic plan view selectively illustrating only a fifth conductive layer of elements of FIG. 6A;

FIG. 12 is a schematic plan view selectively illustrating only a sixth conductive layer of elements of FIG. 6A;

FIG. 13 is a schematic plan view selectively illustrating only first and second conductive layers of elements of FIG. 6A;

FIG. 14 is a schematic plan view selectively illustrating only first and third conductive layers of elements of FIG. 6A;

FIG. 15 is a schematic plan view selectively illustrating only first, second and third conductive layers of elements of FIG. 6A;

FIG. 16 is an enlarged schematic view illustrating a portion corresponding to a first pixel circuit of FIG. 6A;

FIG. 17 is a schematic plan view selectively illustrating only first and third conductive layers of elements of FIG. 16;

FIG. 18 is a schematic cross-sectional view taken along line I-I' of FIG. 16;

FIG. 19 is a schematic cross-sectional view taken along line II-II' of FIG. 16;

FIG. 20 is a schematic cross-sectional view taken along line III-III' of FIG. 16;

FIG. 21 is a schematic plan view illustrating a pixel array of a display device according to an embodiment;

FIG. 22 is a schematic plan view selectively illustrating only a third conductive layer of elements of FIG. 21;

FIG. 23 is a schematic cross-sectional view taken along line I-I' of FIG. 21;

FIG. 24 is a schematic cross-sectional view taken along line II-II' of FIG. 21;

FIG. 25 is a schematic plan view illustrating a pixel array of a display device according to an embodiment;

FIG. 26 is a schematic plan view illustrating a pixel array of a display device according to an embodiment;

FIG. 27 is a schematic cross-sectional view illustrating a structure of a display element according to an embodiment;

FIGS. 28 to 31 are schematic cross-sectional views illustrating a structure of a light emitting element according to an embodiment;

FIG. 32 is a schematic cross-sectional view illustrating an example of an organic light emitting diode of FIG. 30;

FIG. 33 is a schematic cross-sectional view illustrating an example of an organic light emitting diode of FIG. 31;

FIG. 34 is a schematic cross-sectional view illustrating a structure of a pixel of a display device according to an embodiment; and

FIG. 35 is a schematic view illustrating an effect of the disclosure.

[FORM FOR CARRYING OUT THE INVENTION]

The advantages and features of the present invention, and the methods for achieving them, will become clear with reference to the embodiments described below in detail with the accompanying drawings. However, the present invention is not limited to the embodiments disclosed below, but may be implemented in various different forms, and these embodiments are provided only to make the disclosure of the present invention complete and to fully inform those skilled in the art of the invention of the scope of the invention, and the present invention is defined only by the scope of the claims.

When elements or layers are referred to as "on" another element or layer, this includes all cases where another layer or another element is interposed directly over or in the middle of the other element. The same reference numerals refer to the same components throughout the specification. The shapes, sizes, ratios, angles, numbers, etc. disclosed in the drawings for explaining the embodiments are exemplary, and therefore the present invention is not limited to the matters illustrated.

Although the terms "first" and "second" are used to describe various components, these components are of course not limited by these terms. These terms are only used to distinguish one component from another. Therefore, it goes without saying that the first component mentioned below may be the second component within the technical idea of the present invention. The features of each of the various embodiments of the present invention may be partially or wholly combined or combined with each other, and various technical connections and operations are possible, and each embodiment may be implemented independently of each other or may be implemented together in a related relationship. Specific embodiments are described below with reference to the attached drawings.

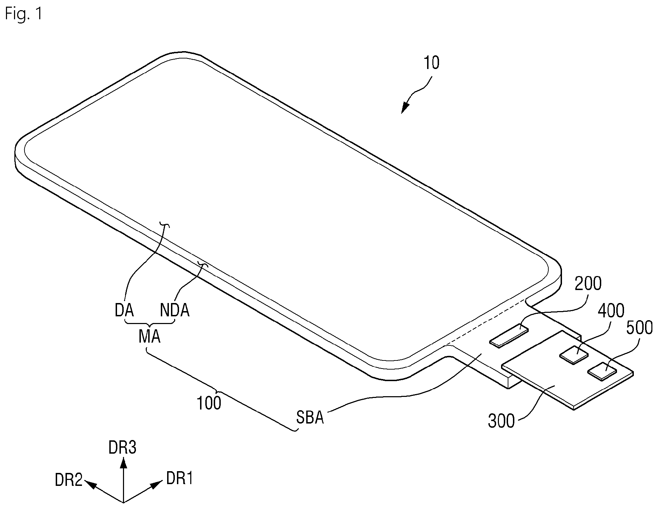

FIG. 1 is a schematic perspective view illustrating a display device according to an embodiment.

Referring to FIG. 1, a display device 10 may be applied to a portable electronic device such as a mobile phone, a smart phone, a tablet personal computer (PC), a mobile communication terminal, an electronic diary, an electronic book, a portable multimedia player (PMP), a navigator, and an ultra mobile PC (UMPC). For example, the display device 10 may be applied to a television, a laptop computer, a monitor, a signboard, or a display unit of an Internet of things (IoT) device. As another example, the display device 10 may be applied to a wearable device such as a smart watch, a watch phone, an eyeglasses-type display, or a head mounted display (HMD).

The display device 10 may be formed in a plane shape similar to a rectangular shape. For example, the display device 10 may have a plane shape similar to a rectangular shape having short sides in a first direction DR1 and long sides in a second direction DR2. A corner where the short side of the first direction DR1 and the long side of the second direction DR2 meets may be rounded to have a predetermined or selected curvature or formed at right angles. The plane shape of the display device 10 may be formed to be similar to another polygonal shape, a circular shape or an oval shape without being limited to the rectangular shape.

The display device 10 may include a display panel 100, a display driver 200, a circuit board 300, a touch driver 400, and a power supply unit 500.

The display panel 100 may include a main area MA and a sub-area SBA.

The main area MA may include a display area DA having pixels displaying an image, and a non-display area NDA disposed near the display area DA. The display area DA may emit light from light emission areas or opening areas. For example, the display panel 100 may include a pixel circuit including switching elements, a pixel defining layer defining a light emission area or an opening area, and a self-light emitting element.

For example, the self-light emitting element may include at least one of an organic light emitting diode including an organic light emitting layer, a quantum dot light emitting diode (LED) including a quantum dot light emitting layer, an inorganic LED including an inorganic semiconductor, and a micro LED.

The non-display area NDA may be an outer area of the display area DA. The non-display area NDA may be defined as an edge area of the main area MA of the display panel 100. The non-display area NDA may include a gate driver (not shown) supplying gate signals to gate lines, and fan-out lines (not shown) connecting the display driver 200 with the display area DA.

The sub-area SBA may be extended from a side of the main area MA. The sub-area SBA may include a flexible material capable of being subjected to bending, folding, rolling and the like. For example, in the case that the sub-area SBA is bent, the sub-area SBA may overlap the main area MA in a thickness direction (e.g., third direction DR3). The sub-area SBA may include a display driver 200, and a pad portion connected to the circuit board 300. Optionally, the sub-area SBA may be omitted, and the display driver 200 and the pad portion may be disposed in the non-display area NDA.

The display driver 200 may output signals and voltages for driving the display panel 100. The display driver 200 may supply data voltages to data lines. The display driver 200 may supply a power voltage to a power line and supply gate control signals to the gate driver.

The display driver 200 may be formed of an integrated circuit (IC), and may be packaged on the display panel 100 by a chip on glass (COG) method, a chip on plastic (COP) method or an ultrasonic bonding method. For example, the display driver 200 may be disposed in the sub-area SBA, and may overlap the main area MA in the thickness direction (third direction DR3) by bending of the sub-area SBA. As another example, the display driver 200 may be packaged on the circuit board 300.

The circuit board 300 may be attached onto the pad portion of the display panel 100 using an anisotropic conductive film (ACF). Lead lines of the circuit board 300 may be electrically connected to the pad portion of the display panel 100. The circuit board 300 may be a flexible printed circuit board, a printed circuit board, or a flexible film such as a chip on film.

The touch driver 400 may be packaged on the circuit board 300. The touch driver 400 may be connected to a touch sensing unit of the display panel 100. The touch driver 400 may supply a touch driving signal to touch electrodes of the touch sensing unit, and may sense a change amount in capacitance between the touch electrodes. For example, the touch driving signal may be a pulse signal having a predetermined or selected frequency. The touch driver 400 may calculate a touch input and touch coordinates based on the change amount in capacitance between the touch electrodes. The touch driver 400 may be formed of an integrated circuit (IC).

The power supply unit 500 may be disposed on the circuit board 300 to supply a power voltage to the display driver 200 and the display panel 100. The power supply unit 500 may generate a first driving voltage to supply the first driving voltage to a first driving voltage line VDL, generate initialization voltages (e.g., a first initialization voltage and a second initialization voltage) to supply the initialization voltages to initialization voltage lines (e.g., a first initialization voltage line VIL1 and a second initialization voltage line VIL2) and generate a common voltage to supply the common voltage to a common electrode common to the light emitting elements of the pixels. For example, the first driving voltage may be a high potential voltage for driving the light emitting element, and the common voltage may be a low potential voltage for driving the light emitting element.

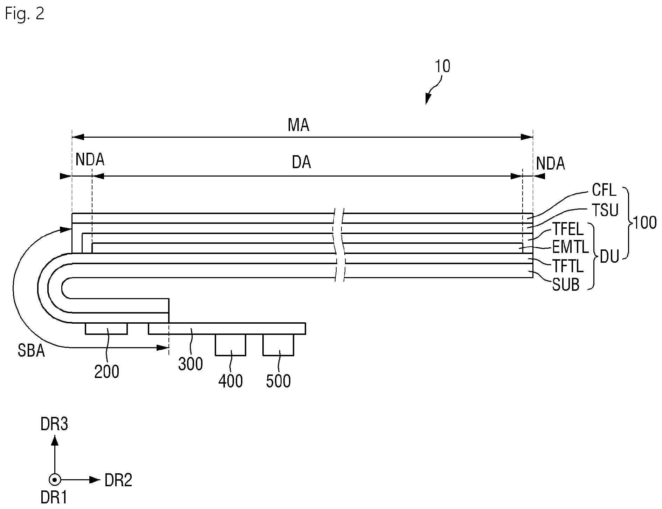

FIG. 2 is a schematic cross-sectional view illustrating a display device according to an embodiment.

Referring to FIG. 2, the display panel 100 may include a display unit DU, a touch sensing unit TSU, and a color filter layer CFL. The display unit DU may include a substrate SUB, a thin film transistor layer TFTL, a light emitting element layer EMTL and an encapsulation layer TFEL.

The substrate SUB may be a base substrate or a base member. The substrate SUB may be a flexible substrate capable of being subjected to bending, folding, rolling or the like. For example, the substrate SUB may include a polymer resin such as polyimide (PI), but is not limited thereto. As another example, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include gate lines, data lines, power lines, gate control lines, fan-out lines for connecting the display driver 200 with the data lines, and lead lines for connecting the display driver 200 with the pad portion. Each of the thin film transistors may include a semiconductor area, a source electrode, a drain electrode and a gate electrode. For example, in the case that the gate driver is formed at a side of the non-display area NDA of the display panel 100, the gate driver may include thin film transistors.

The thin film transistor layer TFTL may be disposed in the display area DA, the non-display area NDA and the sub-area SBA. The thin film transistors, the gate lines, the data lines and the power lines of respective pixels of the thin film transistor layer TFTL may be disposed in the display area DA. The gate control lines and fan-out lines of the thin film transistor layer TFTL may be disposed in the non-display area NDA. The lead lines of the thin film transistor layer TFTL may be disposed in the sub-area SBA.

The light emitting element layer EMTL may be disposed on the thin film transistor layer TFTL. The light emitting element layer EMTL may include a plurality of light emitting elements that include a pixel electrode, a light emitting layer and a common electrode, which may be stacked on each other to emit light, and a pixel defining layer that defines pixels. The light emitting elements of the light emitting element layer EMTL may be disposed in the display area DA.

For example, the light emitting layer may be an organic light emitting layer that includes an organic material. The light emitting layer may include a hole transporting layer, an organic light emitting layer and an electron transporting layer. In the case that the pixel electrode receives a predetermined or selected voltage through the thin film transistor of the thin film transistor layer TFTL and the second electrode receives a cathode voltage, holes and electrons may move to the organic light emitting layer through the hole transporting layer and the electron transporting layer, respectively and may be combined with each other in the organic light emitting layer to emit light. For example, the pixel electrode may be an anode electrode and the common electrode may be a cathode electrode, but the electrodes are not limited thereto.

As another example, the light emitting element may include a quantum dot light emitting diode including a quantum dot light emitting layer, an inorganic light emitting diode including an inorganic semiconductor, or a micro light emitting diode.

The encapsulation layer TFEL may cover an upper surface and sides of the light emitting element layer EMTL and protect the light emitting element layer EMTL. The encapsulation layer TFEL may include at least one inorganic layer and at least one organic layer to encapsulate the light emitting element layer EMTL.

The touch sensing unit TSU may be disposed on the encapsulation layer TFEL. The touch sensing unit TSU may include touch electrodes for sensing a user's touch in a capacitance manner and touch lines for connecting the touch electrodes with the touch driver 400. For example, the touch sensing unit TSU may sense a user's touch in a mutual capacitance manner or a self-capacitance manner.

As another example, the touch sensing unit TSU may be disposed on a separate substrate disposed on the display unit DU. The substrate for supporting the touch sensing unit TSU may be a base member for encapsulating the display unit DU.

The touch electrodes of the touch sensing unit TSU may be disposed in a touch sensor area overlapped with the display area DA. The touch lines of the touch sensing unit TSU may be disposed on a touch peripheral area overlapped with the non-display area NDA.

The color filter layer CFL may be disposed on the touch sensing unit TSU. The color filter layer CFL may include multiple color filters respectively corresponding to the multiple light emission areas. Each of the color filters may selectively transmit light of a particular wavelength and block or absorb light of another wavelength. The color filter layer CFL may absorb a portion of light introduced from the outside of the display device 10 to reduce reflective light due to external light. Therefore, the color filter layer CFL may prevent distortion of a color, which is caused by external light reflection, from occurring.

Since the color filter layer CFL is directly disposed on the touch sensing unit TSU, the display device 10 may not require a separate substrate for the color filter layer CFL. Therefore, a thickness of the display device 10 may be relatively reduced.

The sub-area SBA of the display panel 100 may be extended from a side of the main area MA. The sub-area SBA may include a flexible material capable of being subjected to bending, folding, rolling and the like. For example, in the case that the sub-area SBA is bent, the sub-area SBA may overlap the main area MA in the thickness direction (e.g., the third direction DR3). The sub-area SBA may include a display driver 200, and a pad portion electrically connected to the circuit board 300.

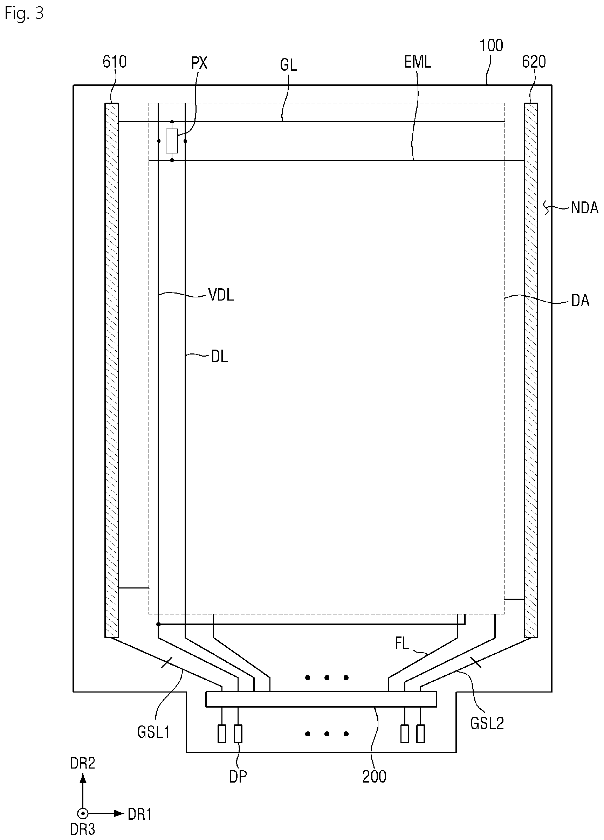

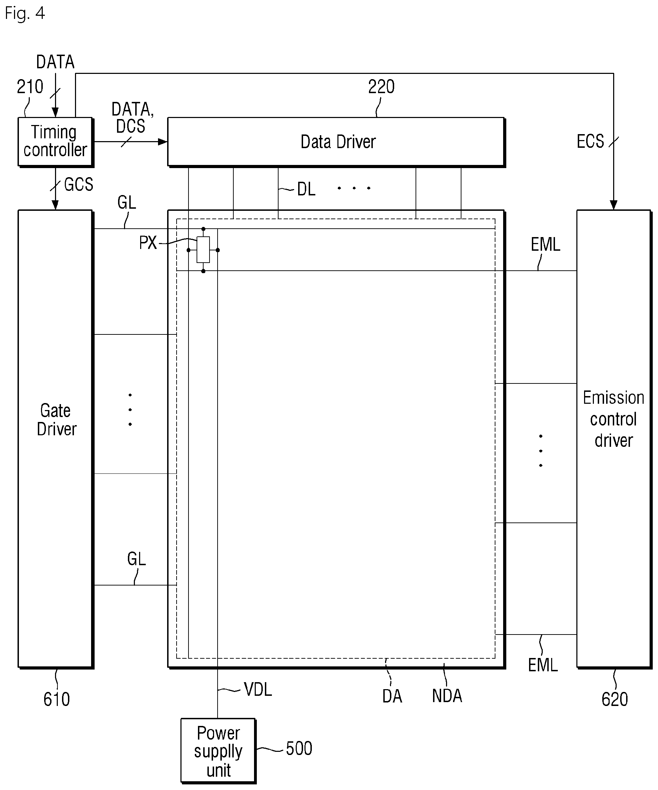

FIG. 3 is a schematic plan view illustrating a display unit of a display device according to an embodiment, and FIG. 4 is a schematic block view illustrating a display panel and a display driver according to an embodiment.

Referring to FIGS. 3 and 4, the display panel 100 may include a display area DA and a non-display area NDA.

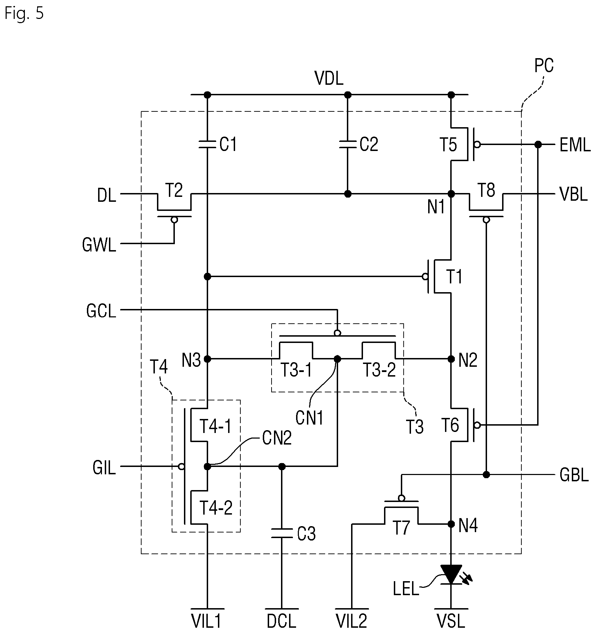

The display area DA may include pixels PX, first driving voltage lines VDL connected to the pixels PX, gate lines GL of second driving voltage lines (VSL in FIG. 5), light emission control lines EML, and data lines DL.

Each of the pixels PX may be connected to the gate line GL, the data line DL, the light emission control line EML, the first driving voltage line VDL and the second driving voltage line VSL. Each of the pixels PX may include at least one transistor, a light emitting element, and a capacitor.

The respective gate lines GL may be extended in the first direction DR1, and may be spaced apart from each other in the second direction DR2 crossing (intersecting) the first direction DR1. The gate lines GL may be arranged along the second direction DR2. The gate lines GL may sequentially supply gate signals to the pixels PX.

The respective light emission controls lines EML may be extended in the first direction DR1, and may be spaced apart from each other in the second direction DR2. The light emission controls lines EML may be arranged along the second direction DR2. The light emission control lines EML may sequentially supply light emission control signals to the pixels PX.

The respective data lines DL may be extended in the second direction DR2, and may be spaced apart from each other in the first direction DR1. The data lines DL may be arranged along the first direction DR1. The data lines DL may sequentially supply data voltages to the pixels PX. The data voltage may determine luminance of each of the pixels PX.

The respective first driving voltage lines VDL may be extended in the second direction DR2, and may be spaced apart from each other in the first direction DR1. The first driving voltage lines VDL may be arranged along the first direction DR1. The first driving voltage lines VDL may supply the first driving voltage to the pixels PX. The first driving voltage may be a high potential voltage for driving the light emitting element.

The non-display area NDA may surround the display area DA. The non-display area NDA may include a gate driver 610, an emission control driver 620, fan-out lines FL, a first gate control line GSL1 and a second gate control line GSL2.

The fan-out lines FL may be extended from the display driver 200 to the display area DA. The fan-out lines FL may supply the data voltages received from the display driver 200 to the data lines DL.

The first gate control line GSL1 may be extended from the display driver 200 to the gate driver 610. The first gate control line GSL1 may supply the gate control signal received from the display driver 200 to the gate driver 610.

The second gate control line GSL2 may be extended from the display driver 200 to the emission control driver 620. The second gate control line GSL2 may supply the light emission control signal ECS received from the display driver 200 to the emission control driver 620.

The sub-area SBA may be extended from a side of the non-display area NDA. The sub-area SBA may include a display driver 200 and a pad portion DP. The pad portion DP may be disposed to be more adjacent to an edge of a side of the sub-area SBA than the display driver 200. The pad portion DP may be electrically connected to the circuit board 300 through an anisotropic conductive film (ACF).

The display driver 200 may include a timing controller 210 and a data driver 220.

The timing controller 210 may receive digital video data DATA and timing signals from the circuit board 300. The timing controller 210 may generate a data control signal DCS based on the timing signals to control an operation timing of the data driver 220, may generate a gate control signal GCS to control an operation timing of the gate driver 610 and may generate a light emission control signal ECS to control an operation timing of the emission control driver 620. The timing controller 210 may supply the gate control signal GCS to the gate driver 610 through the first gate control line GSL1. The timing controller 210 may supply the light emission control signal ECS to the emission control driver 620 through the second gate control line GSL2. The timing controller 210 may supply the digital video data DATA and the data control signal DCS to the data driver 220.

The data driver 220 may convert the digital video data DATA into analog data voltages and supply the analog data voltages to the data lines DL through the fan-out lines FL. The gate signals of the gate driver 610 may select the pixels PX to which the data voltage is supplied, and the selected pixels PX may receive the data voltage through the data lines DL.

The power supply unit 500 may be disposed on the circuit board 300 to supply the power voltage to the display driver 200 and the display panel 100. The power supply unit 500 may generate a first driving voltage to supply the first driving voltage to the first driving voltage line VDL, may generate an initialization voltage to supply the initialization voltage to the initialization voltage line, and may generate a common voltage to supply the common voltage to a common electrode that is common to the light emitting elements of the pixels.

The gate driver 610 may be disposed outside a side of the display area DA or at a side of the non-display area NDA, and the emission control driver 620 may be disposed outside another side of the display area DA or at another side of the non-display area NDA, but the disclosure is not limited thereto. As another example, the gate driver 610 and the emission control driver 620 may be disposed at any of the sides of the non-display area NDA.

The gate driver 610 may include transistors that generate gate signals based on the gate control signal GCS. The emission control driver 620 may include transistors that generate light emission control signals based on the light emission control signal ECS. For example, the transistors of the gate driver 610 and the transistors of the emission control driver 620 may be formed on the same layer as the transistors of each of the pixels PX. The gate driver 610 may supply the gate signals to the gate lines GL, and the emission control driver 620 may supply the light emission control signals to the light emission control lines EML.

FIG. 5 is a schematic circuit view illustrating a pixel of a display device according to an embodiment.

Referring to FIG. 5, a display panel 100 of the display device may include of pixels PX arranged along a row 'p' (p is a natural number) and a column 'q' (q is a natural number). Each of the pixels PX may be connected to a first gate line GWL, a second gate line GCL, a third gate line GIL, a fourth gate line GBL, a light emission control line EML, a data line DL, a first driving voltage line VDL, a second driving voltage line VSL, a first initialization voltage line VIL1, a second initialization voltage line VIL2 and a bias voltage line VBL.

The pixel PX may include a pixel circuit PC and a light emitting element LEL. The pixel circuit may include a first transistor T1, a second transistor T2, a third transistor T3, a fourth transistor T4, a fifth transistor T5, a sixth transistor T6, a seventh transistor T7, an eighth transistor T8, a first capacitor C1, a second capacitor C2 and a third capacitor C3.

The first transistor T1 may include a gate electrode, a source electrode and a drain electrode. The first transistor T1 may control a source-drain current (hereinafter, referred to as a driving current) in accordance with a data voltage applied to the gate electrode. A driving current (e.g., Isd) flowing through a channel area of the first transistor T1 may be proportional to a square of a difference between a voltage (Vsg) between the source electrode and the gate electrode of the first transistor T1 and a threshold voltage Vth ($Isd = k \times (Vsg - Vth)^2$). k denotes a proportional coefficient determined by a structure and physical characteristics of the first transistor T1, Vsg denotes a source-gate voltage of the first transistor T1, and Vth denotes a threshold voltage of the first transistor T1.

The light emitting element LEL may receive the driving current Isd to emit light. The light emission amount or luminance of the light emitting element LEL may be proportional to a magnitude of the driving current Isd.

The light emitting element LEL may be an organic light emitting diode that includes a first electrode, a second electrode and an organic light emitting layer disposed between the first electrode and the second electrode. As another example, the light emitting element LEL may be an inorganic light emitting element that includes a first electrode, a second electrode and an inorganic semiconductor disposed between the first electrode and the second electrode. As another example, the light emitting element LEL may be a quantum dot light emitting element that includes a first electrode, a second electrode and a quantum dot light emitting layer disposed between the first electrode and the second electrode. As another example, the light emitting element LEL may be a micro light emitting diode.

The first electrode of the light emitting element LEL may be electrically connected to a fourth node N4.

The first electrode of the light emitting element LEL may be connected to a drain electrode of the sixth transistor T6 and a source electrode of the seventh transistor T7 through the fourth node N4. The second electrode of the light emitting element LEL may be connected to the second driving voltage line VSL. The second electrode of the light emitting element LEL may receive a second driving voltage (e.g., low potential voltage) from the second driving voltage line VSL.

The second transistor T2 may be turned on by a first gate signal of the first gate line GWL to electrically connect the data line DL with a first node N1 that is a source electrode of the first transistor T1. The second transistor T2 may be turned on based on the first gate signal to supply the data voltage to the first node N1. A gate electrode of the second transistor T2 may be electrically connected to the first gate line GWL, a source electrode of the second transistor T2 may be electrically connected to the data line DL, and a drain electrode of the second transistor T2 may be electrically connected to the first node N1.

The third transistor T3 may be a composite gate transistor (e.g., dual gate transistor) that includes sub-transistors. For example, the third transistor T3 may include a (3-1)th sub-transistor T3-1 (hereinafter, referred to as a (3-1)th transistor T3-1) and a (3-2)th sub-transistor T3-2 (hereinafter, referred to as a (3-2)th transistor T3-2). The (3-1)th transistor T3-1 and the (3-2)th transistor T3-2 may include a gate electrode commonly connected to the second gate line GCL. In other words, the gate electrode of the (3-1)th transistor T3-1 and the gate electrode of the (3-2)th transistor T3-2 may be integrally formed. The (3-1)th transistor T3-1 and the (3-2)th transistor T3-2 may be connected between a third node N3 and a second node N2.

The (3-1)th transistor T3-1 and the (3-2)th transistor T3-2 may be turned on by the second gate signal of the second gate line GCL to electrically connect the second node N2 which is the drain electrode of the first transistor T1 with the third node N3 which is the gate electrode of the first transistor T1. The (3-1)th transistor T3-1 and the (3-2)th transistor T3-2 may be connected in series between the second node N2 and the third node N3. The gate electrode of the (3-1)th transistor T3-1 may be electrically connected to the second gate line GCL, its source electrode may be electrically connected to the third node N3, and its drain electrode may be electrically connected to a source electrode of the (3-2)th transistor T3-2. The gate electrode of the (3-2)th transistor T3-2 may be electrically connected to the second gate line GCL, its source electrode may be electrically connected to the drain electrode of the (3-1)th transistor T3-1, and its drain electrode may be electrically connected to the second node N2. The gate electrode of the (3-1)th transistor T3-1 and the gate electrode of the (3-2)th transistor T3-2 may be integrally formed.

The fourth transistor T4 may be a composite gate transistor (e.g., dual gate transistor) that includes sub-transistors. For example, the fourth transistor T4 may include a (4-1)th sub-transistor T4-1 (hereinafter, referred to as a (4-1)th transistor T4-1) and a (4-2)th sub-transistor T4-2 (hereinafter, referred to as a (4-2)th transistor T4-2). The (4-1)th transistor T4-1 and the (4-2)th transistor T4-2 may include a gate electrode commonly connected to the third gate line GIL. In other words, the gate electrode of the (4-1)th transistor T4-1 and the gate electrode of the (4-2)th transistor T4-2 may be integrally formed. The (4-1)th transistor T4-1 and the (4-2)th transistor T4-2 may be connected between the third node N3 and the first initialization voltage line VIL1.

The (4-1)th transistor T4-1 and the (4-2)th transistor T4-2 may be turned on by the third gate signal of the third gate line GIL to electrically connect the third node N3 which is the gate electrode of the first transistor T1 with the first initialization voltage line VIL1. The (4-1)th transistor T4-1 and the (4-2)th transistor T4-2 may be connected in series between the third node N3 and the first initialization voltage line VIL1. The gate electrode of the (4-1)th transistor T4-1 may be electrically connected to the third gate line GIL, its source electrode may be electrically connected to the third node N3, and its drain electrode may be electrically connected to a source electrode of the (4-2)th transistor T4-2. The gate electrode of the (4-2)th transistor T4-2 may be electrically connected to the third gate line GIL, its source electrode may be electrically connected to the drain electrode of the (4-1)th transistor T4-1, and its drain electrode may be electrically connected to the first initialization voltage line VIL1. The gate electrode of the (4-1)th transistor T4-1 and the gate electrode of the (4-2)th transistor T4-2 may be integrally formed.

A node of the fourth transistor T4, which is a dual gate transistor, for example, a node (hereinafter, referred to as a first common node CN1) between the (4-1)th transistor T4-1 and the (4-2)th transistor T4-2 may be connected with a node (hereinafter, a second common node CN2) between the (3-1)th transistor T3-1 and the (3-2)th transistor T3-2. In other words, the first common node CN1 and the second common node CN2 may be connected to each other.

The fifth transistor T5 may be turned on by the light emission control signal of the light emission control line EML to electrically connect the first driving voltage line VDL with the first node N1 that is the source electrode of the first transistor T1. A gate electrode of the fifth transistor T5 may be electrically connected to the light emission control line EML, its source electrode may be electrically connected to the first driving voltage line VDL, and its drain electrode may be electrically connected to the first node N1.

The sixth transistor T6 may be turned on by the light emission control signal of the light emission control line EML to electrically connect the second node N2, which is the drain electrode of the first transistor T1, with the fourth node N4 that is the first electrode of the light emitting element LEL. A gate electrode of the sixth transistor T6 may be electrically connected to the light emission control line EML, its source electrode may be electrically connected to the second node N2, and its drain electrode may be electrically connected to the fourth node N4.

In the case that the fifth transistor T5, the first transistor T1 and the sixth transistor T6 are all turned on, the driving current may be supplied to the light emitting element LEL.

The seventh transistor T7 may be turned on by a fourth gate signal of the fourth gate line GBL to electrically connect the fourth node N4, which is the first electrode of the light emitting element LEL, with the second initialization voltage line VIL2. The seventh transistor T7 may be turned on based on the fourth gate signal to discharge the first electrode of the light emitting element LEL with the second initialization voltage. The gate electrode of the seventh transistor T7 may be electrically connected to the fourth gate line GBL, its source electrode may be electrically connected to the fourth node N4, and its drain electrode may be electrically connected to the second initialization voltage line VIL2.

The eighth transistor T8 may be turned on by the fourth gate signal of the fourth gate line GBL to electrically connect the bias voltage line VBL with the first node N1 that is the source electrode of the first transistor T1. The eighth transistor T8 may be turned on based on the fourth gate signal to supply the bias voltage to the first node N1. The eighth transistor T8 may supply the bias voltage to the source electrode of the first transistor T1 to improve hysteresis of the first transistor T1. A gate electrode of the eighth transistor T8 may be electrically connected to the fourth gate line GBL, its source electrode may be electrically connected to the bias voltage line VBL, and its drain electrode may be electrically connected to the first node N1.

Each of the first transistor T1, the second transistor T2, the (3-1)th transistor T3-1, the (3-2)th transistor T3-2, the (4-1)th transistor T4-1, the (4-2)th transistor T4-2, the fifth transistor T5, the sixth transistor T6, the seventh transistor T7 and the eighth transistor T8 may include a silicon-based active layer. For example, each of the first transistor T1, the second transistor T2, the (3-1)th transistor T3-1, the (3-2)th transistor T3-2, the (4-1)th transistor T4-1, the (4-2)th transistor T4-2, the fifth transistor T5, the sixth transistor T6, the seventh transistor T7 and the eighth transistor T8 may include an active layer made of low-temperature polycrystalline silicon (LTPS). The active layer made of low-temperature polycrystalline silicon (LTPS) may have high electron mobility and excellent turn-on characteristics. Therefore, the display device 10 may include transistors having excellent turn-on characteristics, thereby stably and efficiently driving the pixels PX.

Each of the first transistor T1, the second transistor T2, the (3-1)th transistor T3-1, the (3-2)th transistor T3-2, the (4-1)th transistor T4-1, the (4-2)th transistor T4-2, the fifth transistor T5, the sixth transistor T6, the seventh transistor T7 and the eighth transistor T8 may correspond to a P-type transistor. For example, each of the first transistor T1, the second transistor T2, the (3-1)th transistor T3-1, the (3-2)th transistor T3-2, the (4-1)th transistor T4-1, the (4-2)th transistor T4-2, the fifth transistor T5, the sixth transistor T6, the seventh transistor T7 and the eighth transistor T8 may output a current, which flows into the source electrode, to the drain electrode based on a gate low voltage applied to the gate electrode.

For example, at least one of the first transistor T1, the second transistor T2, the (3-1)th transistor T3-1, the (3-2)th transistor T3-2, the (4-1)th transistor T4-1, the (4-2)th transistor T4-2, the fifth transistor T5, the sixth transistor T6, the seventh transistor T7, and the eighth transistor T8 may include an oxide-based active layer. The transistor, which includes the oxide-based active layer, may have a coplanar structure in which a gate electrode is disposed on an upper portion. The transistor, which includes the oxide-based active layer, may correspond to an n-type transistor, and may output a current, which flows into the drain electrode, to the source electrode based on a gate high voltage applied to the gate electrode.

The first capacitor C1 may be electrically connected between the third node N3, which is the gate electrode of the first transistor T1, and the first driving voltage line VDL. For example, a first electrode of the first capacitor C1 may be electrically connected to the third node N3, and its second electrode may be electrically connected to the first driving voltage line VDL, thereby maintaining a potential difference between the first driving voltage line VDL and the gate electrode of the first transistor T1.

The second capacitor C2 may be electrically connected between the first node N1, to which the first, second, fifth and eighth transistors T1, T2, T5 and T8 are connected, and the first driving voltage line VDL. For example, a first electrode of the second capacitor C2 may be electrically connected to the first node N1, and its second electrode may be electrically connected to the first driving voltage line VDL. The second capacitor C2 may temporarily store the data voltage (e.g., the data voltage from the data line) input to the first node N1 through the second transistor T2.

The third capacitor C3 may include a first electrode and a second electrode, which are disposed to face each other. The first electrode of the third capacitor C3 may be integrally formed with the first common node CN1 and the second common node CN2. The second electrode of the third capacitor C3 may be connected to a direct current power source (or constant power source; for example, the power supply unit 500). For example, the first electrode of the third capacitor C3 may connect the first common node CN1 with the second common node CN2, and the second electrode of the third capacitor C3 may be connected to the direct current power source through a direct current power line DCL.

The direct current power line DCL may be supplied with a direct current voltage from the power supply unit 500, for example. Therefore, the direct current voltage may be applied to the second electrode of the third capacitor C3. The direct current power line DCL may be any one of the first driving voltage line VDL, the second driving voltage line VSL, the first initialization voltage line VIL1, the second initialization voltage line VIL2 and the bias voltage line VBL.

The first electrode of the third capacitor C3 may have a structure that connects the first common node CN1 with the second common node CN2 and thus may have a wide area as much as a connection path between the first common node CN1 and the second common node CN2, so that a capacity of the third capacitor C3 may be increased. Therefore, a kickback voltage (e.g., kickback voltage of the first common node CN1 or kickback voltage of the second common node CN2) of the dual gate transistor (e.g., the third transistor T3 and the fourth transistor T4) may be reduced, whereby a leakage current (e.g., current leaked through a transistor in the case that the transistor is turned off; hereinafter, referred to as an off-leakage current) of the dual gate transistor may be reduced. This will be described in detail with reference to the accompanying drawings.

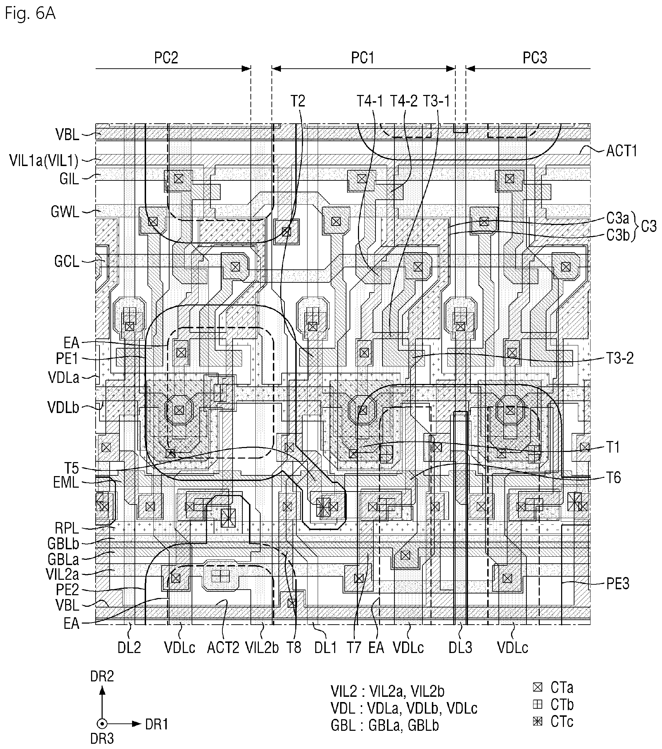

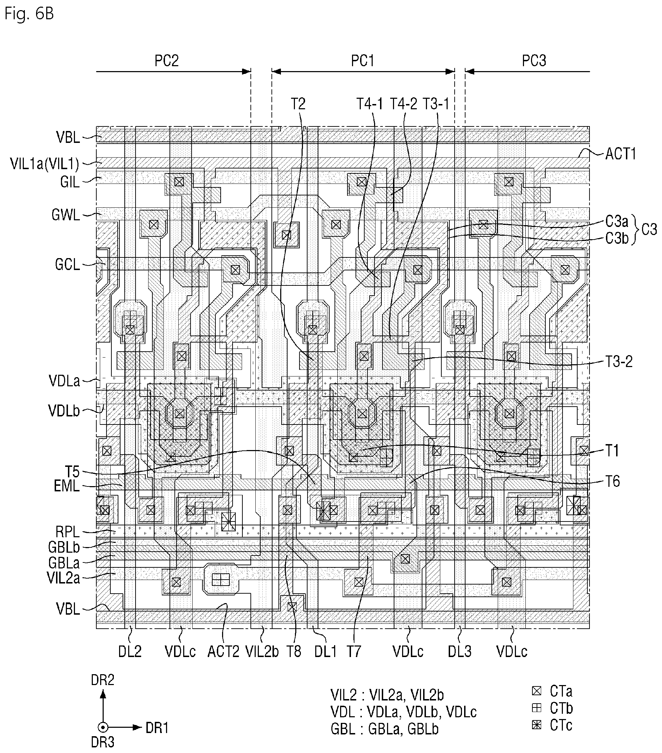

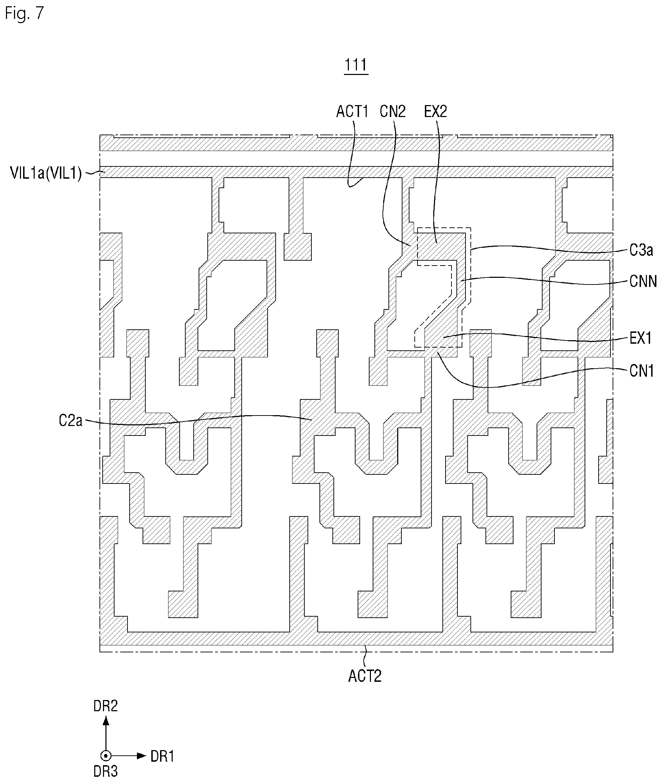

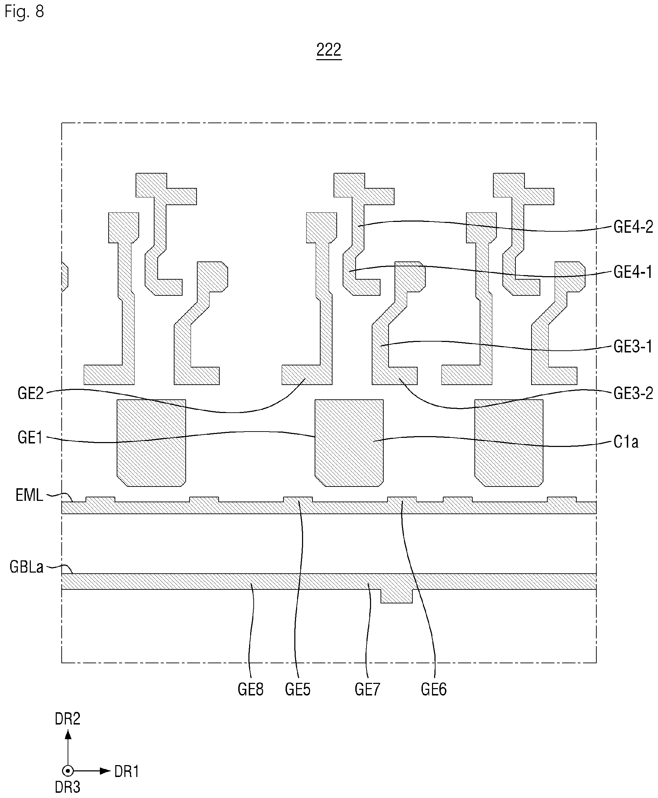

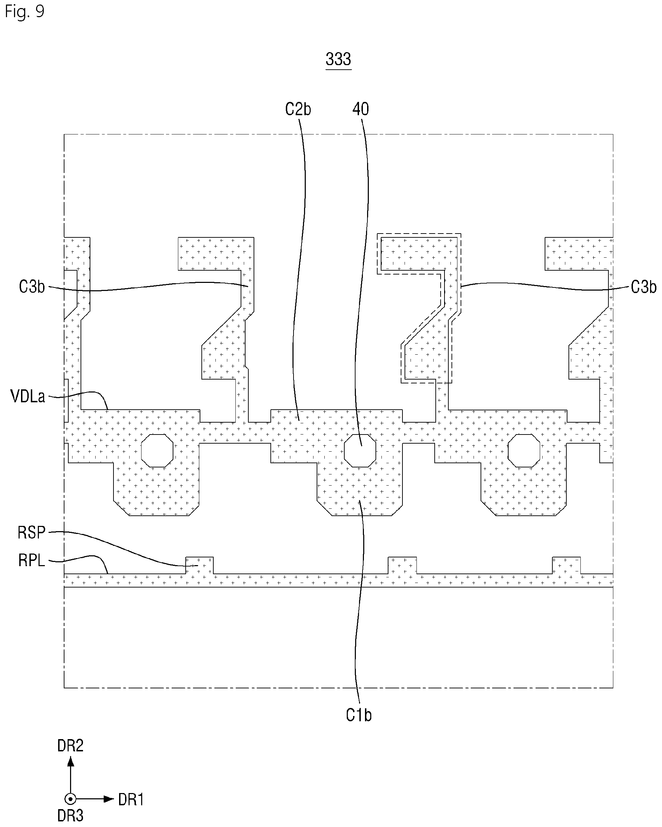

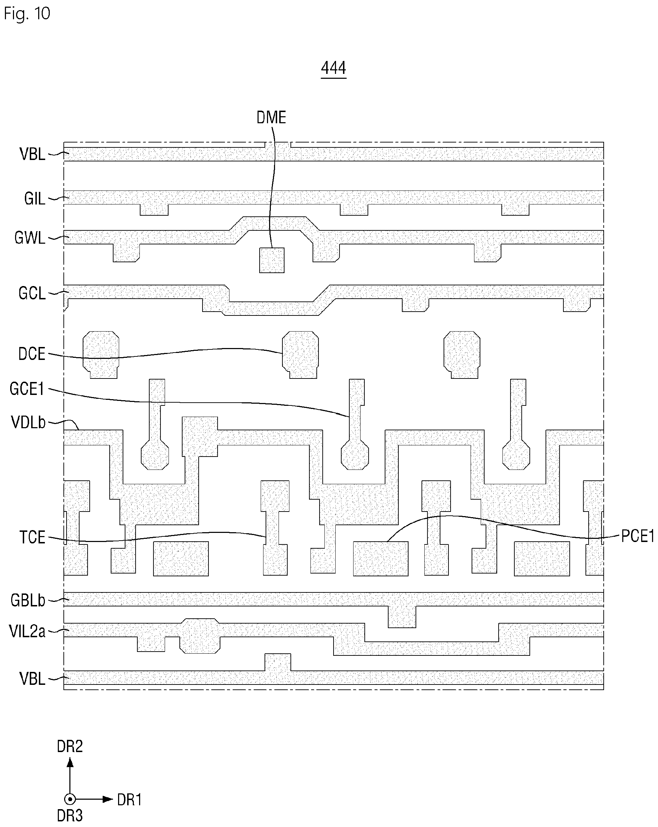

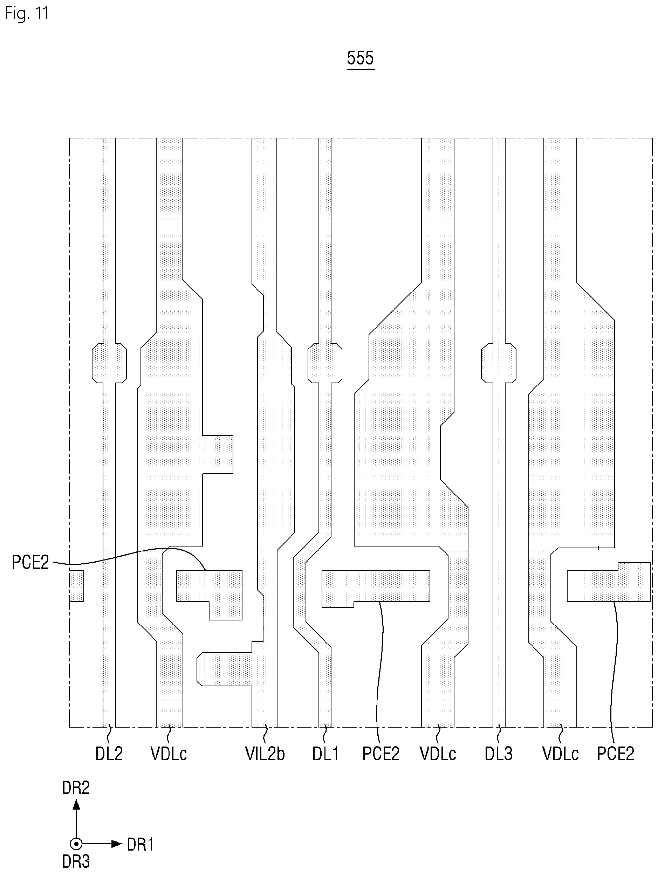

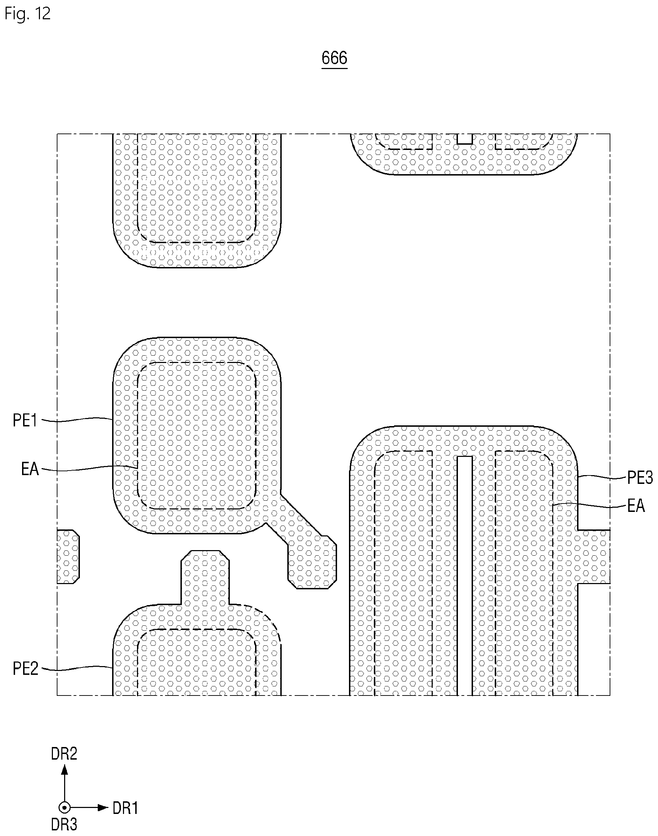

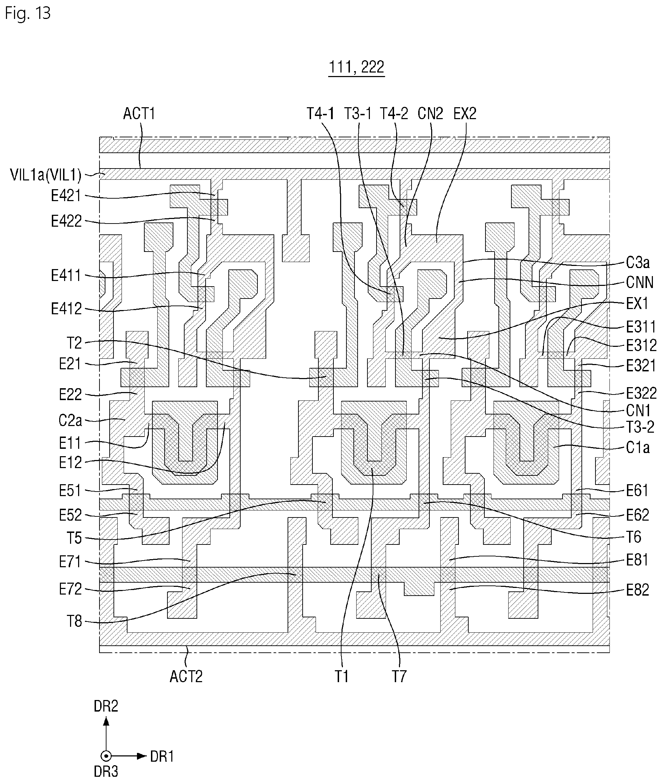

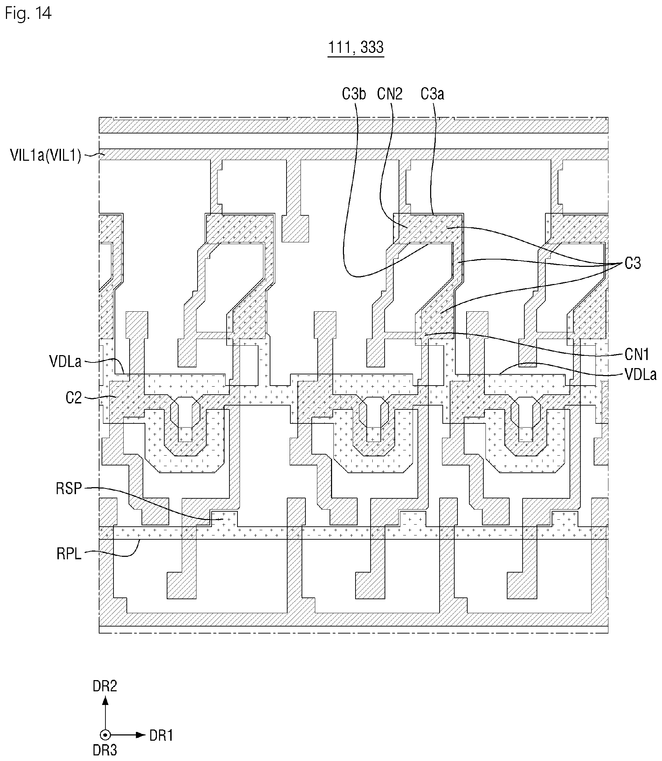

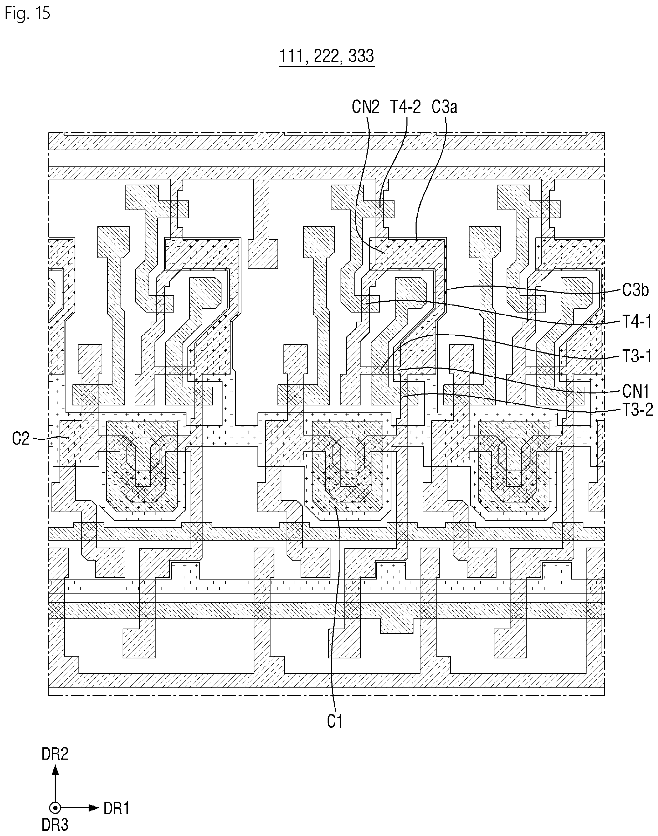

FIG. 6A is a schematic plan view illustrating a pixel array of a display device according to an embodiment of the disclosure, which includes a pixel circuit of FIG. 5. FIG. 6B is a schematic plan view illustrating that pixel electrodes and light emission areas are removed from FIG. 6A. FIG. 7 is a schematic plan view selectively illustrating only a first conductive layer 111 of elements of FIG. 6A. FIG. 8 is a schematic plan view selectively illustrating only a second conductive layer 222 of elements of FIG. 6A. FIG. 9 is a schematic plan view selectively illustrating only a third conductive layer 333 of elements of FIG. 6A. FIG. 10 is a schematic plan view selectively illustrating only a fourth conductive layer 444 of elements of FIG. 6A. FIG. 11 is a schematic plan view selectively illustrating only a fifth conductive layer 555 of elements of FIG. 6A. FIG. 12 is a schematic plan view selectively illustrating only a sixth conductive layer 666 of elements of FIG. 6A. FIG. 13 is a schematic plan view selectively illustrating only first and second conductive layers 111, 222 of elements of FIG. 6A. FIG. 14 is a schematic plan view selectively illustrating only first and third conductive layers 111, 333 of elements of FIG. 6A. FIG. 15 is a schematic plan view selectively illustrating only first, second and third conductive layers 111, 222, 333 of elements of FIG. 6A.

As shown in FIGS. 6A and 6B, contact holes may be divided into a first type contact hole CTa, a second type contact hole CTb and a third type contact hole CTc. The first type contact hole CTa may be a contact hole for connecting the conductive layer 444, which will be described later, with a conductive layer (for example, at least one of the first to third conductive layers 111, 222, 333) directly below the fourth conductive layer 444. The second type contact hole CTb may be a contact hole for connecting the fifth conductive layer 555 with a conductive layer (for example, at least one of the first to fourth conductive layers 111, 222, 333, 444) directly below the fifth conductive layer 555. The third type contact hole CTc may be a contact hole for connecting the sixth conductive layer 666 with a conductive layer (for example, one of the first to fifth conductive layers) directly below the sixth conductive layer 666.

The display device 10 according to an embodiment of the disclosure, as shown in FIGS. 6A and 6B, may include first to third pixel circuits PC1 to PC3 and first to third pixel electrodes PE1 to PE3 connected to the first to third pixel circuits PC1 to PC3, respectively. The first pixel circuit PC1 and the first pixel electrode PE1 may be a pixel circuit and a pixel electrode of a first pixel, the second pixel circuit PC2 and the second pixel electrode PE2 may be a pixel circuit and a pixel electrode of a second pixel, and the third pixel circuit PC3 and the third pixel electrode PE3 may be a pixel circuit and a pixel electrode of a third pixel. The first to third pixels may constitute a unit pixel.

The first to third pixels of the unit pixel may include light emitting layers that provide light of different wavelengths. For example, the first pixel may include a light emitting layer that provides light of a first wavelength (e.g., light of a red wavelength), the second pixel may include a light emitting layer that provides light of a second wavelength (e.g., light of a green wavelength), and the third pixel may include a light emitting layer that provides light of a third wavelength (e.g., light of a blue wavelength).

The first wavelength may correspond to a red wavelength, the second wavelength may correspond to a green wavelength, and the third wavelength may correspond to a blue wavelength, but the disclosure is not limited thereto. For example, the first wavelength may correspond to a green wavelength, the second wavelength may correspond to a red wavelength, and the third wavelength may correspond to a blue wavelength. As another example, the first wavelength may correspond to a green wavelength, the second wavelength may correspond to a blue wavelength, and the third wavelength may correspond to a red wavelength. As another example, the first wavelength may correspond to a blue wavelength, the second wavelength may correspond to a red wavelength, and the third wavelength may correspond to a green wavelength. As another example, the first wavelength may correspond to a blue wavelength, the second wavelength may correspond to a green wavelength, and the third wavelength may correspond to a red wavelength.

Each of the pixel circuits PC1 to PC3 of the pixels may include first to eighth transistors T1 to T8, a first capacitor C1, a second capacitor C2 and a third capacitor C3. For example, each of the pixel circuits PC1 to PC3 of the first to third pixels will be described in detail. The first pixel circuit PC1 may include first to eighth transistors T1 to T8, a first capacitor C1 and a second capacitor C2, which are disposed in an area defined by being surrounded by a second upper initialization voltage line VIL2b, a third data line DL3 and two bias voltage lines VBL adjacent to each other in the second direction DR2. The first pixel circuit PC1 may be connected to, for example, a first pixel electrode PE1, a first data line DL1, a first gate line GWL, a second gate line GCL, a third gate line GIL, a fourth gate line GBL, a light emission control line EML, a first driving voltage line VDL, a first initialization voltage line VIL1, a second initialization voltage line VIL2 and the bias voltage line VBL. The second pixel circuit PC2 may include first to eighth transistors T1 to T8 disposed at a left side of the first pixel circuit PC1, a first capacitor C1 and a second capacitor C2. The second pixel circuit PC2 may be connected to, for example, a second pixel electrode PE2, a second data line DL2, the first gate line GWL, the second gate line GCL, the third gate line GIL, the fourth gate line GBL, the light emission control line EML, the first driving voltage line VDL, the first initialization voltage line VIL1, the second initialization voltage line VIL2 and the bias voltage line VBL.

The third pixel circuit PC3 may include first to eighth transistors T1 to T8 disposed at a right side of the first pixel circuit PC1, a first capacitor C1 and a second capacitor C2. The third pixel circuit PC3 may be connected to, for example, a third pixel electrode PE3, a third data line DL3, the first gate line GWL, the second gate line GCL, the third gate line GIL, the fourth gate line GBL, the light emission control line EML, the first driving voltage line VDL, the first initialization voltage line VIL1, the second initialization voltage line VIL2 and the bias voltage line VBL.

The first conductive layer 111 may be disposed on the substrate along the third direction DR3. As shown in FIGS. 6A and 6B, 7, 13, 14 and 15, the first conductive layer 111 may include a first semiconductor layer ACT1 and a second semiconductor layer ACT2.

A portion of the first semiconductor layer ACT1 and a portion of the second semiconductor layer ACT2 may constitute the first to eighth transistors T1 to T8 together with gate electrodes that will be described later. For example, as shown in FIG. 13, the first semiconductor layer ACT1 may include a first electrode E11 of the first transistor T1, a second electrode E12 of the first transistor T1, a channel area of the first transistor T1, a first electrode E21 of the second transistor T2, a second electrode of the second transistor T2, a channel area of the second transistor T2, a first electrode E311 of the (3-1)th transistor T3-1, a second electrode E312 of the (3-1)th transistor T3-1, a channel area of the (3-1)th transistor T3-1, a first electrode E321 of the (3-2)th transistor T3-2, a second electrode E322 of the (3-2)th transistor T3-2, a channel area of the (3-2)th transistor T3-2, a first electrode E411 of the (4-1)th transistor T4-1, a second electrode E412 of the (4-1)th transistor T4-1, a channel area of the (4-1)th transistor T4-1, a first electrode E421 of the (4-2)th transistor T4-2, a second electrode E422 of the (4-2)th transistor T4-2, a channel area of the (4-2)th transistor T4-2, a first electrode E51 of the fifth transistor T5, a second electrode E52 of the fifth transistor T5, a channel area of the fifth transistor T5, a first electrode E61 of the sixth transistor T6, a second electrode E62 of the sixth transistor T6, a channel area of the sixth transistor T6, a first electrode E71 of the seventh transistor T7, a second electrode E72 of the seventh transistor T7, and a channel area of the seventh transistor T7. The second semiconductor layer ACT2 may include a first electrode E81 of the eighth transistor T8, a second electrode E82 of the eighth transistor T8 and a channel area of the eighth transistor T8. A first electrode of each of the transistors T1 to T8 may be one of a source electrode and a drain electrode thereof, and a second electrode of each of the transistors T1 to T8 may be the other of the source electrode and the drain electrode thereof.

The first semiconductor layer ACT1 may include a first lower initialization voltage line VIL1a. In other words, a portion of the first semiconductor layer ACT1 may be the first lower initialization voltage line VIL1a. The first lower initialization voltage line VIL1a may be extended along the first direction DR1. As shown in FIGS. 7 and 13, the first lower initialization voltage line VIL1a may be integrally formed with the first electrode of the (4-2)th transistor T4-2. In other words, the first lower initialization voltage line VIL1a may be integrally formed with a portion corresponding to the first electrode of the (4-2)th transistor T4-2 of the first semiconductor layer ACT1. The first lower initialization voltage line VIL1a may be connected to the first upper initialization voltage line extended along the second direction DR2 through a contact hole. Therefore, the initialization voltage line may have a mesh shape. The first upper initialization voltage line may be made of, for example, the fifth conductive layer 555 that will be described later.

The first semiconductor layer ACT1 may include a second lower capacitor electrode C2a which is an electrode of the second capacitor C2.

The first semiconductor layer ACT1 may include a third lower capacitor electrode C3a that is an electrode of the third capacitor C3. For example, as shown in FIGS. 7 and 13, the third lower capacitor electrode C3a may include a first extension portion EX1, a second extension portion EX2 and a connection portion CNN. The first extension portion EX1, the second extension portion EX2 and the connection portion CNN may be integrally formed.

The first extension portion EX1 may be extended from the first common node CN1 that is a contact point between the sub-transistors included in the third transistor T3, which is a dual gate transistor, for example, a contact point between the (3-1)th transistor T3-1 and the (3-2)th transistor T3-2 along the second direction DR2 (e.g., extension direction of the first data line DL1). As shown in FIG. 13, the first common node CN1 may be connected to the first lower initialization voltage line VIL1a through the third lower capacitor electrode C3a and the (4-2)th transistor T4-2.

The second extension portion EX2 may be extended from the second common node CN2 that is a contact point between the sub-transistors included in the fourth transistor T4, which is a dual gate transistor, for example, a contact point between the (4-1)th transistor T4-1 and the (4-2)th transistor T4-2 along the first direction DR1 (e.g., extension direction of the first gate line GWL). As shown in FIG. 13, the second common node CN2 may be connected to the first lower initialization voltage line VIL1a through the (4-2)th transistor T4-2.

The connection portion CNN may connect the first extension portion EX1 with the second extension portion EX2. For example, the connection portion CNN may be extended from an end of the first extension portion EX1 along the second direction DR2 and thus may be connected to an end of the second extension portion EX2. A portion of the connection portion CNN may have a curved shape, and the curved portion may be connected to the first extension portion EX1.

As shown in FIGS. 7 and 13, the first electrode E311 (e.g., source electrode) of the (3-1)th transistor T3-1 (e.g., source electrode) and the second E312 (e.g. drain electrode) of the (3-1)th transistor T3-1, the first common node CN1, the third lower capacitor electrode C3a, the second common node CN2, a first electrode T411 (e.g., drain electrode) of the (4-1)th transistor T4-1 and a second electrode T412 (e.g., source electrode) of the (4-1)th transistor T4-1 may be connected to one another to form a closed loop shape.

For example, the first electrode E311 of the (3-1)th transistor T3-1, the second electrode E312 of the (3-1)th transistor T3-1, the first common node CN1, the first extension portion EX1, the connection portion CNN, the second extension portion EX2, the second common node CN2, the first electrode E411 of the (4-1)th transistor T1-1 and the second electrode E412 of the (4-1)th transistor T4-1 may be connected to one another to have a closed loop shape. At this time, the closed loop may surround, for example, at least a portion of the gate electrode of the (3-1)th transistor T3-1. For example, as shown in FIGS. 6A, 8 and 13, the closed loop may surround a portion of a (3-1)th gate electrode GE3-1 of the (3-1)th transistor T3-1, which is in contact with the second gate line GCL. The (3-1)th gate electrode GE3-1 and the second gate line GCL may be connected to each other through a first type contact hole CTa of an insulating layer, and the aforementioned closed loop may surround a portion of the (3-1)th gate electrode GE3-1 that overlaps the first type contact hole CTa.

The second conductive layer 222 may be disposed on the first conductive layer 111 along the third direction DR3. The insulating layer may be disposed between the first conductive layer 111 and the second conductive layer 222. As shown in FIGS. 6A and 6B and 8, the second conductive layer 222 may include a first gate electrode GE1, a second gate electrode GE2, a (3-1)th gate electrode GE3-1, a (3-2)th gate electrode GE3-2, a (4-1)th gate electrode GE4-1, a (4-2)th gate electrode GE4-2, a fifth gate electrode GE5, a sixth gate electrode GE6, a seventh gate electrode GE7, an eighth gate electrode GE8, a light emission control line EML and a fourth lower gate line GBLa.

The first gate electrode GE1 may be used as the gate electrode of the first transistor T1. As shown in FIG. 13, the first gate electrode GE1 may overlap a portion of the first semiconductor layer ACT1. A first channel area of the first transistor T1 may be formed in an overlap area between the first gate electrode GE1 and the first semiconductor layer ACT1, and the first electrode E11 and the second electrode E12 of the first transistor T1 may be formed in areas of the first semiconductor layer ACT1 at both sides of the first channel area. The first gate electrode GE1 may include the first lower capacitor electrode C1a that is an electrode of the first capacitor C1.

The second gate electrode GE2 may be used as the gate electrode of the second transistor T2. As shown in FIG. 13, a second channel area of the second transistor T2 may be formed in an overlap area between the second gate electrode GE2 and the first semiconductor layer ACT1, and the first electrode E21 and the second electrode E22 of the second transistor T2 may be formed in the areas of the first semiconductor layer ACT1 at both sides of the second channel area.

The (3-1)th gate electrode GE3-1 may be used as the gate electrode of the (3-1)th transistor T3-1. As shown in FIG. 13, a (3-1)th channel area of the (3-1)th transistor T3-1 may be formed in an overlap area between the (3-1)th gate electrode GE3-1 and the first semiconductor layer ACT1, and the first electrode E311 and the second electrode E312 of the (3-1)th transistor T3-1 may be formed in the areas of the first semiconductor layer ACT1 at both sides of the (3-1)th channel area, respectively.

The (3-2)th gate electrode GE3-2 may be used as the gate electrode of the (3-2)th transistor T3-2. As shown in FIG. 13, a (3-2)th channel area of the (3-2)th transistor T3-2 may be formed in an overlap area between the (3-2)th gate electrode GE3-2 and the first semiconductor layer ACT1, and the first electrode E321 and the second electrode E322 of the (3-2)th transistor T3-2 may be formed in the areas of the first semiconductor layer ACT1 at both sides of the (3-2)th channel area, respectively. The (3-2)th gate electrode GE3-2 and the (3-1)th gate electrode GE3-1 may be integrally formed.

The (4-1)th gate electrode GE4-1 may be used as the gate electrode of the (4-1)th transistor T4-1. As shown in FIG. 13, a (4-1)th channel area of the (4-1)th transistor T4-1 may be formed in an overlap area between the (4-1)th gate electrode GE4-1 and a first semiconductor layer ACT1, and the first electrode E411 and the second electrode E412 of the (4-1)th transistor T4-1 may be formed in the areas of the first semiconductor layer ACT1 at both sides of the (4-1)th channel area, respectively.

The (4-2)th gate electrode GE4-2 may be used as the gate electrode of the (4-2)th transistor T4-2. As shown in FIG. 13, a (4-2)th channel area of the (4-2)th transistor T4-2 may be formed in an overlap area between the (4-2)th gate electrode GE4-2 and the first semiconductor layer ACT1, and the first electrode E421 and the second electrode E422 of the (4-2)th transistor T4-2 may be formed in the areas of the first semiconductor layer ACT1 at both sides of the (4-2)th channel area, respectively. The (4-2)th gate electrode GE4-2 and the (4-1)th gate electrode GE4-1 may be integrally formed.

The fifth gate electrode GE5 may be used as the gate electrode of the fifth transistor T5. As shown in FIG. 13, a fifth channel area of the fifth transistor T5 may be formed in an overlap area between the fifth gate electrode GE5 and the first semiconductor layer ACT1, and the first electrode E51 and the second electrode E52 of the fifth transistor T5 may be formed in the areas of the first semiconductor layer ACT1 at both sides of the fifth channel area, respectively.

The sixth gate electrode GE6 may be used as the gate electrode of the sixth transistor T6. As shown in FIG. 13, a sixth channel area of the sixth transistor T6 may be formed in an overlap area between the sixth gate electrode GE6 and the first semiconductor layer ACT1, and the first electrode E61 and the second electrode E62 of the sixth transistor T6 may be formed in the areas of the first semiconductor layer ACT1 at both sides of the sixth channel area, respectively. The sixth gate electrode GE6 and the fifth gate electrode GE5 may be integrally formed.

The seventh gate electrode GE7 may be used as the gate electrode of the seventh transistor T7. As shown in FIG. 13, a seventh channel area of the seventh transistor T7 may be formed in an overlap area between the seventh gate electrode GE7 and the first semiconductor layer ACT1, and the first electrode E71 and the second electrode E72 of the seventh transistor T7 may be formed in the areas of the first semiconductor layer ACT1 at both sides of the seventh channel area, respectively.

The eighth gate electrode GE8 may be used as the gate electrode of the eighth transistor T8. As shown in FIG. 13, an eighth channel area of the eighth transistor T8 may be formed in an overlap area between the eighth gate electrode GE8 and the second semiconductor layer ACT2, and the first electrode E81 and the second electrode E82 of the eighth transistor T8 may be formed in areas of the second semiconductor layer ACT2 at both sides of the eighth channel area, respectively. The eighth gate electrode GE8 and the seventh gate electrode GE7 may be integrally formed.

The light emission control line EML may be extended along the first direction DR1. The light emission control line EML may include the fifth gate electrode GE5 and the sixth gate electrode GE6, which are described above. In other words, a portion of the light emission control line EML may be the fifth gate electrode GE5 and the sixth gate electrode GE6.

The fourth lower gate line GBLa may be extended along the first direction DR1. The fourth lower gate line GBLa may include the seventh gate electrode GE7 and the eighth gate electrode GE8, which are described above. In other words, a portion of the fourth lower gate line GBLa may be the seventh gate electrode GE7 and the eighth gate electrode GE8. The third conductive layer 333 may be disposed on the second conductive layer 222 along the third direction DR3. An insulating layer may be disposed between the second conductive layer 222 and the third conductive layer 333. As shown in FIGS. 6A and 6B, 9, 14 and 15, the third conductive layer 333 may include a first lower driving voltage line VDLa and a repair line RPL.

The first lower driving voltage line VDLa may be extended along the first direction DR1. The first lower driving voltage line VDLa may have a hole 40 passing therethrough in the third direction DR3. The first lower driving voltage line VDLa may include a first upper capacitor electrode C1b, a second upper capacitor electrode C2b and a third upper capacitor electrode C3b.

The first upper capacitor electrode C1b may be extended from the first lower driving voltage line VDLa along a reverse direction (hereinafter, referred to as a second reverse direction) of the second direction DR2. The first upper capacitor electrode C1b may overlap the first lower capacitor electrode C1a in the third direction DR3. The first capacitor C1 may be formed in an overlap area between the first lower capacitor electrode C1a and the first upper capacitor electrode C1b. For example, the first lower capacitor electrode C1a and the first upper capacitor electrode C1b may be the first electrode and the second electrode of the first capacitor C1, respectively.

The second upper capacitor electrode C2b may overlap the aforementioned second lower capacitor electrode C2a in the third direction DR3. The second capacitor C2 may be formed in an overlap area between the second lower capacitor electrode C2a and the second upper capacitor electrode C2b. For example, the second lower capacitor electrode C2a and the second upper capacitor electrode C2b may be the first electrode and the second electrode of the second capacitor C2, respectively.

The third upper capacitor electrode C3b may be extended from the first lower driving voltage line VDLa along the second direction DR2. The third upper capacitor electrode C3b may overlap the third lower capacitor electrode C3a in the third direction DR3. The third capacitor C3 may be formed in an overlap area between the third lower capacitor electrode C3a and the third upper capacitor electrode C3b. For example, the third lower capacitor electrode C3a and the third upper capacitor electrode C3b may be the first electrode and the second electrode of the third capacitor C3, respectively. The third upper capacitor electrode C3b may have the same or similar shape as or to that of the third lower capacitor electrode C3b

may have an area larger than that of the third lower capacitor electrode C3a.

The repair line RPL may be extended along the first direction DR1. The repair line RPL may include, for example, a repair short portion RSP extended from the repair line RPL in the second direction DR2. The repair short portion RSP may be disposed to overlap a contact hole connecting a pixel electrode (e.g., the first pixel electrode PE1) with a second pixel connection electrode PCE2. The repair line RPL may transmit a repair voltage. The repair line RPL may be used to transmit the repair voltage to a pixel electrode of a defective pixel, and the pixel electrode of the defective pixel and the repair short portion RSP of the repair line RPL may be connected to each other by laser irradiation. The laser may be irradiated from a lower portion of the substrate toward the repair short portion RSP.

The fourth conductive layer 444 may be disposed on the third conductive layer 333 along the third direction DR3. An insulating layer may be disposed between the third conductive layer 333 and the fourth conductive layer 444. As shown in FIGS. 6A and 6B and 10, the fourth conductive layer 444 may include a third gate line GIL, a first gate line GWL, a dummy electrode DME, a second gate line GCL, a data connection electrode DCE, a first intermediate driving voltage line VDLb, a first gate connection electrode GCE1, a transistor connection electrode TCE, a first pixel connection electrode PCE1, a fourth upper gate line GBLb, a second lower initialization voltage line VIL2a, and a bias voltage line VBL. The first gate line GWL, the second gate line GCL, the third gate line GIL, the fourth upper gate line GBLb, the second lower initialization voltage line VIL2a and the bias voltage line VBL may be extended along the first direction DR1.

The first gate line GWL may be connected to the second gate electrode GE2 of the second transistor T2 through a contact hole (e.g., the first type contact hole CTa) of the insulating layer.

The second gate line GCL may be connected to the (3-1)th gate electrode GE3-1 of the (3-1)th transistor T3-1 and the (3-2)th-th gate electrode GE3-2 of the (3-2)th transistor T3-2 through the contact hole (e.g., the first type contact hole CTa) of the insulating layer.

The third gate line GIL may be connected to the (4-1)th gate electrode GE4-1 of the (4-1)th transistor T4-1 and the (4-2)th gate electrode GE4-2 of the (4-2)th transistor T4-2 through the contact hole (e.g., the first type contact hole CTa) of the insulating layer.

The fourth upper gate line GBLb may be connected to the fourth lower gate line GBLa through the contact hole (e.g., the first type contact hole CTa) of the insulating layer. The fourth lower gate line GBLa and the fourth upper gate line GBLb may constitute the fourth gate line GBL.

The dummy electrode DME may be disposed between the first gate line GWL and the second gate line GCL. The dummy electrode DME may be disposed on a line that is not connected to the second upper initialization voltage line VIL2b that will be described later, and may be disposed for regularity of a pattern in the pixel.

The data connection electrode DCE may be connected to the first electrode E21 of the second transistor T2 through the contact hole (e.g., the first type contact hole CTa) of the insulating layer. For example, the data connection electrode DCE may be connected to a portion corresponding to the first electrode of the second transistor T2 of the first semiconductor layer ACT1 through the contact hole of the insulating layer described above. The first gate connection electrode GCE1 may be connected to the first gate electrode GE1 through the contact hole (e.g., the first type contact hole CTa) of the insulating layer and the hole 40 of the first lower driving voltage line VDLa. The first gate connection electrode GCE1 may be connected to the (4-2)th electrode E412 of the (4-1)th transistor T(4-1) through the contact hole for example, a first type contact hole CTa of an insulating layer. For example, the first gate connection electrode GCE1 may be connected to a portion corresponding to the (4-2)th electrode E412 of the (4-1)th transistor T(4-1) through the contact hole of the insulating layer described above.

The first intermediate driving voltage line VDLb may have a curved shape in a portion in which the first gate connection electrode GCE1 is disposed so that the first intermediate driving voltage line VDLb may be extended in the first direction DR1 by bypassing the first gate connection electrode GCE1. A portion of the first gate connection electrode GCE1 may be disposed in a U-shaped groove defined by the curved portion of the first intermediate driving voltage line VDLb. The first intermediate driving voltage line VDLb may be connected to the first lower driving voltage line VDLa through the contact hole (e.g., the first type contact hole CTa) of the insulating layer. The first intermediate driving voltage line VDLb may be connected to the second electrode E52 of the fifth transistor T5 through the contact hole (e.g., the first type contact hole CTa) of the insulating layer. For example, the first intermediate driving voltage line VDLb may be connected to a portion corresponding to the second electrode E52 of the fifth transistor T5 of the first semiconductor layer ACT1 through the contact hole of the aforementioned insulating layer. The first pixel connection electrode PCE1 may be connected to the second electrode E62 of the sixth transistor T6 through the contact hole (e.g., the first type contact hole CTa) of the insulating layer. For example, the first pixel connection electrode PCE1 may be connected to a portion corresponding to the second electrode E62 of the sixth transistor T6 of the first semiconductor layer ACT1 through the contact hole of the aforementioned insulating layer.

The transistor connection electrodes TCE may connect transistors that include different semiconductor layers. For example, the transistor connection electrode TCE may connect the first electrode E51 of the fifth transistor T5 with the first electrode E81 of the eighth transistor T8. At this time, a side and another side of the transistor connection electrode TCE may be connected to the first electrode E51 of the fifth transistor T5 and the first electrode E81 of the eighth transistor T8 through the contact hole (e.g., the first type contact hole CTa) passing through the insulating layer, respectively. For example, a side of the transistor connection electrode TCE may be connected to a portion corresponding to the first electrode E51 of the fifth transistor T5 of the first semiconductor layer ACT1 through the contact hole of the aforementioned insulating layer, and another side of the transistor connection electrode TCE may be connected to a portion corresponding to the first electrode E81 of the eighth transistor T8 of the second semiconductor layer ACT2 through the contact hole of the aforementioned insulating layer.

The second lower initialization voltage line VIL2a may be connected to the first semiconductor layer ACT1 through the contact hole (e.g., the first type contact hole CTa) of the insulating layer. For example, the second lower initialization voltage line VIL2a may be connected to a portion corresponding to the second electrode E71 of the seventh transistor T7 of the first semiconductor layer ACT1 through the contact hole of the aforementioned insulating layer.

The bias voltage line VBL may be connected to the second semiconductor layer ACT2 through the contact hole (e.g., the first type contact hole CTa) of the insulating layer. For example, the bias voltage line VBL may be connected to a portion corresponding to the second electrode E82 of the eighth transistor T8 of the second semiconductor layer ACT2 through the contact hole of the aforementioned insulating layer.

The fifth conductive layer 555 may be disposed on the fourth conductive layer 444 along the third direction DR3. An insulating layer may be disposed between the fourth conductive layer 444 and the fifth conductive layer 555. As shown in FIGS. 6A and 6B and 11, the fifth conductive layer 555 may include a second data line DL2, a first upper driving voltage line VDLc, a second pixel connection electrode PCE2, a second upper initialization voltage line VIL2b, a first data line DL1 and a third data line DL3.

Each of the second data line DL2, the first upper driving voltage line VDLc, the second upper initialization voltage line VIL2b, the first data line DL1 and the third data line DL3 may be extended along the second direction DR2.

The first data line DL1, the second data line DL2 and the third data line DL3 may be connected to the corresponding data connection electrode DCE through a corresponding contact hole (e.g., the second type contact hole CTb) of the insulating layer.

The first upper driving voltage line VDLc may be connected to the first intermediate driving voltage line VDLb through the contact hole (e.g., the second type contact hole CTb) of the insulating layer, and as described above, the first intermediate driving voltage line VDLb may be connected to the first lower driving voltage line VDLa through the contact hole (e.g., the first type contact hole CTa). The first upper driving voltage lines VDLc, the first intermediate driving voltage lines VDLb connected to the first upper driving voltage lines VDLc, and the first lower driving voltage lines VDLa connected to the first intermediate driving voltage lines VDLb may form the first driving voltage line VDL. The first driving voltage line VDL that includes the first upper driving voltage lines VDLc and the first intermediate driving voltage lines VDLb (and/or the first lower driving voltage lines VDLa) crossing the first upper driving voltage lines VDLc may have a mesh shape. The second upper initialization voltage line VIL2b may be connected to the second lower initialization voltage line VIL2a through the contact hole (e.g., the second type contact hole CTb) of the insulating layer. The second upper initialization voltage lines VIL2b and the second lower initialization voltage lines VIL2a connected to the second upper initialization voltage lines VIL2b may constitute the second initialization voltage line VIL2. The second initialization voltage line VIL2 that includes the second upper initialization voltage lines VIL2b and the second lower initialization voltage lines VIL2a crossing the second upper initialization voltage lines VIL2b may have a mesh shape.

The fifth conductive layer 555 may further include a first upper initialization voltage line extended in the second direction DR2. The first upper initialization voltage line may be connected to the first lower initialization voltage line VIL1a through the contact hole (e.g., the second type contact hole CTb) of the insulating layer. The first upper initialization voltage lines and the first lower initialization voltage lines VIL1a connected thereto may constitute the first initialization voltage line VIL1. The first initialization voltage line VIL1 that includes the first upper initialization voltage lines and the first lower initialization voltage lines VIL1a crossing the first upper initialization voltage lines may have a mesh shape.

The second pixel connection electrode PCE2 may be connected to the first pixel connection electrode PCE1 through the contact hole (e.g., the second type contact hole CTb) of the insulating layer. The second pixel connection electrode PCE2 may overlap the repair short portion RSP of the aforementioned repair line RPL in the third direction DR3.

The sixth conductive layer 666 may be disposed on the fifth conductive layer 555 along the third direction DR3. An insulating layer may be disposed between the fifth conductive layer 555 and the sixth conductive layer 666. As shown in FIGS. 6A and 6B and 12, the sixth conductive layer 666 may include a first pixel electrode PE1, a second pixel electrode PE2 and a third pixel electrode PE3. Each of the pixel electrodes PE1, PE2 and PE3 may be connected to the aforementioned second pixel connection electrode PCE2 through a corresponding contact hole (e.g., the third type contact hole CTc) of the insulating layer.

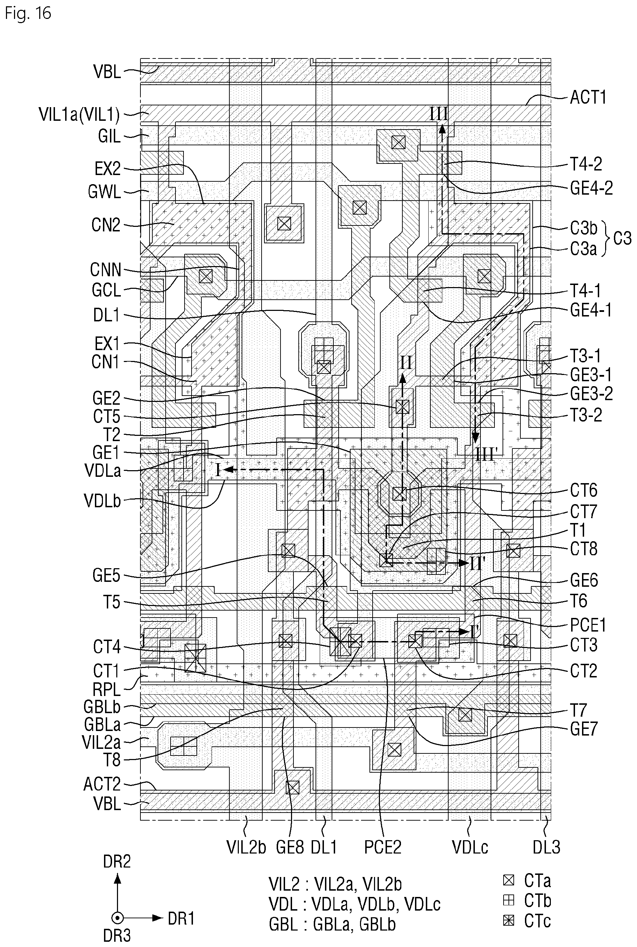

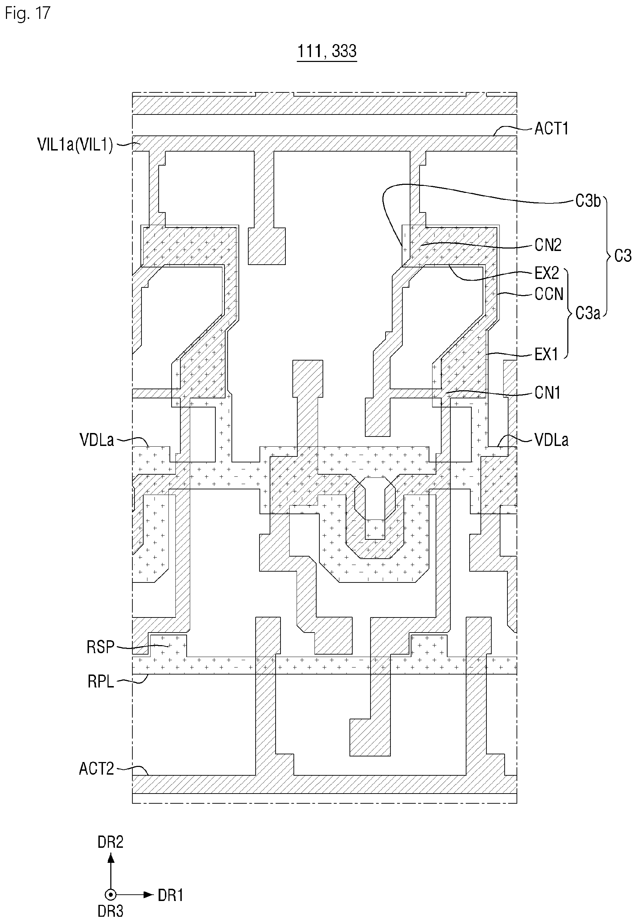

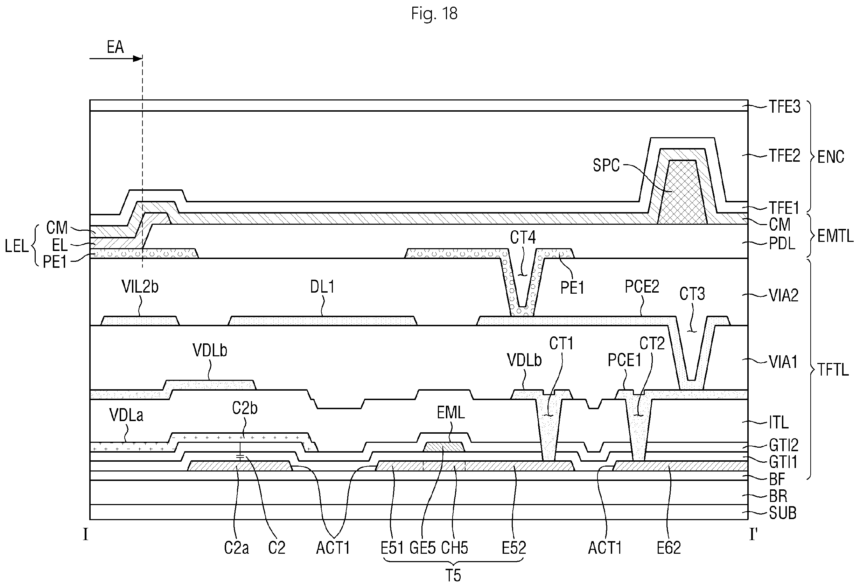

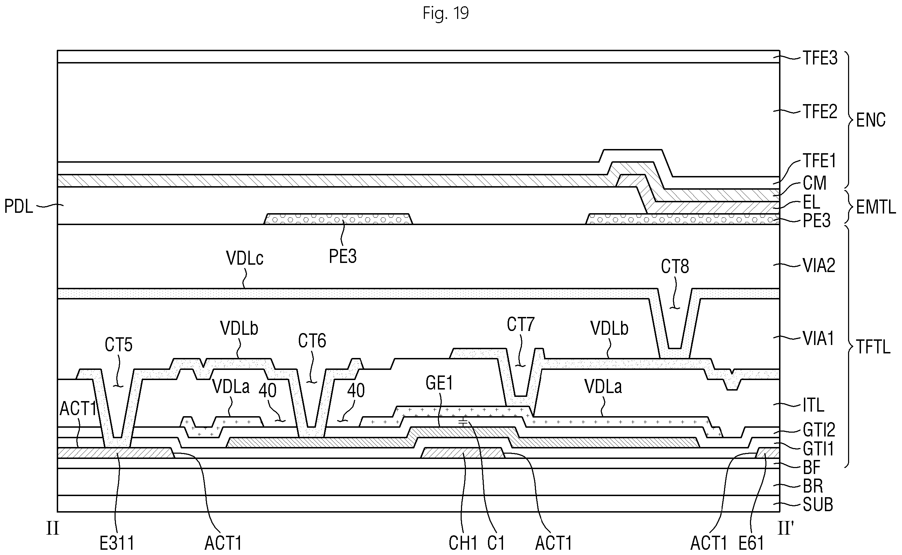

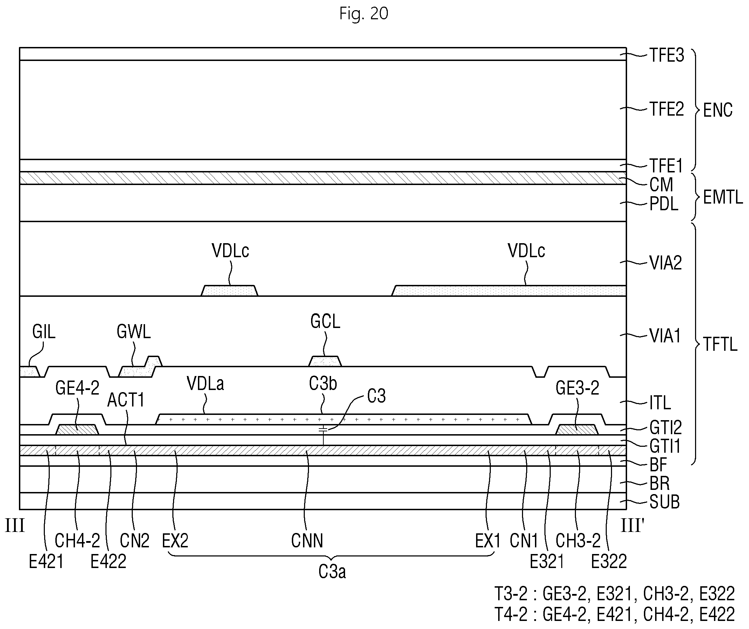

FIG. 16 is an enlarged schematic view illustrating a portion corresponding to a first pixel circuit PC1 of FIG. 6A. FIG. 17 is a schematic plan view selectively illustrating only first and third conductive layers 111, 333 of elements of FIG. 16. FIG. 18 is a schematic cross-sectional view taken along line I-I' of FIG. 16. FIG. 19 is a schematic cross-sectional view taken along line II-II' of FIG. 16. FIG. 20 is a schematic cross-sectional view taken along line III-III' of FIG. 16.

As shown in FIGS. 18 to 20, the display device 10 may include a substrate SUB, a barrier layer BR, a thin film transistor layer TFTL, a light emitting element layer EMTL, and an encapsulation layer ENC. The barrier layer BR, the thin film transistor TFTL layer, the light emitting element layer EMTL and the encapsulation layer ENC may be sequentially disposed on the substrate SUB along the third direction DR3. The thin film transistor layer TFTL may include the aforementioned pixel circuit (e.g., the first pixel circuit PC1).

The substrate SUB may be a rigid substrate, or a flexible substrate capable of being subjected to bending, folding, rolling or the like. The substrate SUB may be made of an insulating material such as glass, quartz and/or a polymer resin. Examples of the polymer material include polyethersulfone (PES), polyacrylate (PA), polyarylate (PAR), polyetherimide (PEI), polyethylene naphthalate (PEN), polyethyleneterephthalate (PET), polyphenylene sulfide (PPS), polyallylate, polyimide (PI), polycarbonate (PC), cellulose triacetate (CAT), cellulose acetate propionate (CAP), or combinations thereof. In another embodiment, the substrate SUB may include a metal material.

The barrier layer BR may be disposed on the substrate SUB. The barrier layer BR may be a layer for protecting the transistors T1 to T8 of the thin film transistor layer TFTL and the light emitting layer EL of the light emitting element layer TFTL from moisture permeated through the substrate SUB vulnerable to moisture permeation. The barrier layer BR may include multiple inorganic layers that are stacked on each other. For example, the barrier layer BR may be formed of a multi-layer in which one or more inorganic layers of a silicon nitride layer, a silicon oxynitride layer, a silicon oxide layer, a titanium oxide layer and an aluminium oxide layer are stacked on each other.

The buffer layer BF may be disposed on the barrier layer BR. The buffer layer BF may be a layer for protecting the transistors of the thin film transistor layer TFTL and the light emitting layer EL of the light emitting element layer EMTL from moisture permeated through the substrate SUB vulnerable to moisture permeation. The buffer layer BF may include multiple inorganic layers that are stacked on each other. For example, the buffer layer BF may be formed of a multi-layer in which one or more inorganic layers of a silicon nitride layer, a silicon oxynitride layer, a silicon oxide layer, a titanium oxide layer and an aluminium oxide layer are stacked on each other.

The first conductive layer 111 may be disposed on the buffer layer BF. For example, as shown in FIGS. 7 and 16 to 20, the first semiconductor layer ACT1 and the second semiconductor layer ACT2 may be disposed on the substrate SUB as the first conductive layer 111. FIG. 18 illustrates an example in which the first semiconductor layer ACT1 including the second lower capacitor electrode C2a, the first electrode E51 of the fifth transistor T5, a fifth channel area CH5 of the fifth transistor T5, the second electrode E52 of the fifth transistor T5 and the second electrode E62 of the sixth transistor T6 may be disposed on the buffer layer BF. FIG. 19 illustrates an example in which the first semiconductor layer ACT1 including the first electrode E311 of the (3-1)th transistor T3-1, a first channel area CH1 of the first transistor T1 and the first electrode E61 of the sixth transistor T6 may be disposed on the buffer layer BF. FIG. 20 illustrates an example in which the first semiconductor layer ACT1 including the first extension portion EX1 of the third lower capacitor electrode C3a, the second extension portion EX2 of the third lower capacitor electrode C3a, the connection portion CNN of the third lower capacitor electrode C3a, the first common node CN1, the second common node CN2, the first electrode E321 of the (3-2)th transistor T3-2, a (3-2)th channel area CH3-2 of the (3-2)th transistor T3-2, the second electrode E322 of the (3-2)th transistor T3-2, the first electrode E421 of the (4-2)th transistor T4-2, a (4-2)th channel area CH4-2 of the (4-2)th transistor T4-2 and the second electrode E422 of the (4-2)th transistor T4-2 may be disposed on the buffer layer BF.

A first gate insulating layer GTI1 may be disposed on the first conductive layer 111. The first gate insulating layer GTI1 may be disposed on an entire surface of the substrate including the first conductive layer 111. The first gate insulating layer GTI1 may include at least one of TetraEthylOrthoSilicate (TEOS), silicon nitride (SiNx), and silicon oxide ($SiO_2$). For example, the first gate insulating layer GTI1 may have a double-layered structure in which a silicon nitride film having a thickness of about 40 nm and a TetraEthylOrthoSilicate film having a thickness of about 80 nm are stacked on each other. The second conductive layer 222 may be disposed on the first gate insulating layer GTI1. For example, as shown in FIGS. 8 and 16 to 20, the first gate electrode GE1, the second gate electrode GE2, the (3-1)th gate electrode GE3-1, the (3-2)th gate electrode GE3-2, the (4-1)th gate electrode GE4-1, the (4-2)th gate electrode GE4-2, the fifth gate electrode GE5, the sixth gate electrode GE6, the seventh gate electrode GE7, the eighth gate electrode GE8, the light emission control line EML and the fourth lower gate line GBLa may be disposed on the first gate insulating layer GTI1. An example in which the light emission control line EML including the fifth gate electrode GE5 is disposed on the first gate insulating layer GTI1 is illustrated in FIG. 18, and thus the fifth gate electrode GE5 may be disposed on the first gate insulating layer GTI1 to overlap the first semiconductor layer ACT1. The fifth channel area CH5 may be formed in an area overlapped by the fifth gate electrode GE5 of the first semiconductor layer ACT1. An example in which the first gate electrode GE1 is disposed on the first gate insulating layer GTI1 to overlap the first semiconductor layer ACT1 is illustrated in FIG. 19, and thus the first channel area CH1 may be formed in an area overlapped by the first gate electrode GE1 of the first semiconductor layer ACT1. An example in which the (3-2)th gate electrode GE3-2 and the (4-2)th gate electrode GE4-2 are disposed on the first gate insulating layer GTI1 to overlap the first semiconductor layer ACT1 is illustrated in FIG. 20. The (3-2)th channel area CH3-2 may be formed in an area overlapped by the (3-2)th gate electrode GE3-2 of the first semiconductor layer ACT1, and the (4-2)th channel area CH4-2 may be formed in an area overlapped by the (4-2)th gate electrode GE4-2 of the first semiconductor layer ACT1.

The second gate insulating layer GTI2 may be disposed on the second conductive layer 222. The second gate insulating layer GTI2 may be disposed on the entire surface of the substrate including the second conductive layer 222. The second gate insulating layer GTI2 may be formed of the same material and structure as those of the first gate insulating layer GTI1.

The third conductive layer 333 may be disposed on the second gate insulating layer GTI2. For example, as shown in FIGS. 9 and 16 to 20, the first lower driving voltage line VDLa and the repair line RPL may be disposed on the second gate insulating layer GTI2. An example in which the first lower driving voltage line VDLa including the second upper capacitor electrode C2b is disposed on the second gate insulating layer GTI2 is illustrated in FIG. 18, and thus the first lower driving voltage line VDLa may be disposed on the second gate insulating layer GTI2 to overlap the first semiconductor layer ACT1. At this time, the second capacitor C2 may be formed in an overlap area between the first lower driving voltage line VDLa and the first semiconductor layer ACT1. An example in which the first lower driving voltage line VDLa is disposed on the second gate insulating layer GTI2 to overlap the first gate electrode GE1 is illustrated in FIG. 19, and thus the first capacitor C1 may be formed in an overlap area between the first lower driving voltage line VDLa and the first gate electrode GE1. An example in which the first lower driving voltage line VDLa including the third upper capacitor electrode C3b is disposed on the second gate insulating layer GTI2 to overlap the first semiconductor layer ACT1 is illustrated in FIG. 20, and thus the third capacitor C3 may be formed in an overlap area between the first lower driving voltage line VDLa and the first semiconductor layer ACT1.

An interlayer insulating layer ITL may be disposed on the third conductive layer 333. The interlayer insulating layer ITL may be disposed on the entire surface of the substrate SUB including the third conductive layer 333. The interlayer insulating layer ITL may have a thickness greater than that of the second gate insulating layer GTI2. The thickness may mean a size in the third direction DR3. The interlayer insulating layer ITL may include an inorganic layer, for example, a silicon nitride layer, a silicon oxynitride layer, a silicon oxide layer, a titanium oxide layer, and/or an aluminium oxide layer. The interlayer insulating layer ITL may include multiple inorganic layers.

The fourth conductive layer 444 may be disposed on the interlayer insulating layer ITL. For example, as shown in FIGS. 10 and 16 to 20, the third gate line GIL, the first gate line GWL, the dummy electrode DME, the second gate line GCL, the data connection electrode DCE, the first intermediate driving voltage line VDLb, the first gate connection electrode GCE1, the transistor connection electrode TCE, the first pixel connection electrode PCE1, the fourth upper gate line GBLb, the second lower initialization voltage line VIL2a and the bias voltage line VBL may be disposed on the interlayer insulating layer ITL. An example in which the first intermediate driving voltage line VDLb and the first pixel connection electrode PCE1 are disposed on the interlayer insulating layer ITL is illustrated in FIG. 18. The first intermediate driving voltage line VDLb may be connected to the second electrode E52 of the fifth transistor T5 through a first contact hole CT1 passing through the interlayer insulating layer ITL, the second gate insulating layer GTI2 and the first gate insulating layer GTI1. The first pixel connection electrode PCE1 may be connected to the second electrode E62 of the sixth transistor T6 through a second contact hole CT2 passing through the interlayer insulating layer ITL, the second gate insulating layer GTI2 and the first gate insulating layer GTI1. An example in which the first intermediate driving voltage line VDLb is connected to the first electrode E311 of the (3-1)th transistor T3-1 through a fifth contact hole CT5 passing through the interlayer insulating layer ITL, the second gate insulating layer GTI2 and the first gate insulating layer GTI1, an example in which the first intermediate driving voltage line VDLb is connected to the first gate GE1 through a sixth contact hole CT6 passing through the interlayer insulating layer ITL, the hole 40 of the first lower driving voltage line VDLa and the second gate insulating layer GTI2, and an example in which the first intermediate driving voltage line VDLb is connected to the first lower driving voltage line VDLa through a seventh contact hole CT7 passing through the interlayer insulating layer ITL are illustrated in FIG. 19. An example in which the third gate line GIL, the first gate line GWL and the second gate line GCL are disposed on the interlayer insulating layer ITL is illustrated in FIG. 20. The first contact hole CT1, the second contact hole CT2, the fifth contact hole CT5, the sixth contact hole CT6 and the seventh contact hole CT7 may correspond to the aforementioned first type contact hole CTa.

A first planarization layer VIA1 may be disposed on the fourth conductive layer 444. The first planarization layer VIA1 may be disposed on the entire surface of the substrate SUB including the fourth conductive layer 444.

The first planarization layer VIA1 may include an organic layer such as an acryl resin, an epoxy resin, a phenolic resin, a polyamide resin and/or a polyimide resin.

The fifth conductive layer 555 may be disposed on the first planarization layer VIA1. For example, as shown in FIGS. 11 and 16 to 20, the second data line DL2, the first upper driving voltage line VDLc, the second pixel connection electrode PCE2, the second upper initialization voltage line VIL2b, the first data line DL1 and the third data line DL3 may be disposed on the first planarization layer VIA1. An example in which the second upper initialization voltage line VIL2b, the first data line DL1 and the second pixel connection electrode PCE2 are disposed on the first planarization layer VIA1 is illustrated in FIG. 18. The second pixel connection electrode PCE2 may be connected to the first pixel connection electrode PCE1 through a third contact hole CT3 passing through the first interlayer insulating layer ITL. An example in which the first upper driving voltage line VDLc is disposed on the first planarization layer VIA1 is illustrated in FIG. 19. The first upper driving voltage line VDLc may be connected to the first intermediate driving voltage line VDLb through an eighth contact hole CT8 passing through the first planarization layer VIA1. An example in which the first upper driving voltage line VDLc is disposed on the first planarization layer VIA1 is illustrated in FIG. 20. The third contact hole CT3 and the eighth contact hole CT8 may correspond to the aforementioned second type contact hole CTb.

A second planarization layer VIA2 may be disposed on the fifth conductive layer 555. The second planarization layer VIA2 may be disposed on the entire surface of the substrate SUB including the fifth conductive layer 555. The second planarization layer VIA2 may have the same material and structure as those of the first planarization layer VIA1.

The light emitting element layer EMTL including the sixth conductive layer 666 may be disposed on the second planarization layer VIA2. For example, as shown in FIGS. 12 and 16 to 20, the first pixel electrode PE1, the second pixel electrode PE2 and the third pixel electrode PE3 may be disposed on the second planarization layer VIA2. An example in which the first pixel electrode PE1 is disposed on the first planarization layer VIA1 is illustrated in FIG. 18. The first pixel electrode PE1 may be connected to the second pixel connection electrode PCE2 through a fourth contact hole CT4 passing through the second planarization layer VIA2. An example in which the third pixel electrode PE3 is disposed on the second planarization layer VIA2 is illustrated in FIG. 19. The fourth contact hole CT4 may correspond to the aforementioned third type contact hole CTc.

The light emitting element layer EMTL may further include light emitting elements LEL and a bank PDL (or a pixel defining layer) in addition to the sixth conductive layer 666.

The light emitting elements LEL may include, for example, a first light emitting element LEL connected to the first pixel circuit PC1, a second light emitting element connected to the second pixel circuit PC2 and a third light emitting element connected to the third pixel circuit PC3. The first light emitting element LEL may include a first pixel electrode PE1, a first light emitting layer and a common electrode CM. The second light emitting element may include a second pixel electrode PE2, a second light emitting layer and a common electrode CM. The third light emitting element may include a third pixel electrode PE3, a light emitting layer and a common electrode CM. Hereinafter, as the description of the light emitting elements, the first light emitting element LEL connected to the first pixel circuit PC1 will be described.

The first light emitting element LEL may include a first pixel electrode PE3, a light emitting layer EL and a common electrode CM. The light emission area EA may include a first pixel electrode PE1, a light emitting layer EL and a common electrode CM, which are stacked on each other such that holes from the first pixel electrode PE1 and electrons from the common electrode CM are combined with each other in the light emitting layer to emit light. The first pixel electrode PE1 may be an anode electrode of the first light emitting element LEL, and the common electrode CM may be a cathode electrode of the first light emitting element LEL.

In a top emission structure in which light is emitted in a direction of the common electrode CM based on the light emitting layer EL, the pixel electrode may be formed of a single layer of molybdenum (Mo), titanium (Ti), copper (Cu) or aluminium (Al), or may be formed of a stacked structure (Ti/Al/Ti) of aluminium (Al) and titanium (Ti), a stacked structure (ITO/Al/ITO) of aluminium (Al) and indium tin oxide (ITO), an APC alloy, or a stacked structure (ITO/APC/ITO) of APC alloy and ITO. The APC alloy may be an alloy of silver (Ag), palladium (Pd) and copper (Cu).

The bank PDL (or pixel defining layer) may serve to define light emission areas EA of the pixels. To this end, the bank PDL may be disposed to expose a portion of the first pixel electrode PE1 on the second planarization layer VIA2. The bank PDL may cover an edge of the first pixel electrode PE1. Although not shown, the bank PDL may be disposed in the fourth contact hole CT4 passing through the second planarization layer VIA2. Therefore, the fourth contact hole CT4 passing through the second planarization layer VIA2 may be filled by the bank PDL. The bank PDL may be formed of an organic layer such as acryl resin, epoxy resin, phenolic resin, polyamide resin and/or polyimide resin.

As shown in FIG. 18, a spacer SPC may be disposed on the bank PDL. The spacer SPC may serve to support a mask during a process of manufacturing the light emitting layer EL. The spacer SPC may be formed of an organic layer such as acryl resin, epoxy resin, phenolic resin, polyamide resin or polyimide resin.

The light emitting layer EL may be formed on the first pixel electrode PE1. The light emitting layer EL may include an organic material to emit a predetermined or selected color. For example, the light emitting layer EL may include a hole transporting layer, an organic material layer and an electron transporting layer. The organic material layer may include a host and a dopant. The organic material layer may include a material for emitting predetermined or selected light, and may be formed using a phosphorescent material or a fluorescent material.

For example, the organic material layer of the first light emitting layer of the first light emission area emitting light of a first color may include a host material that includes carbazole biphenyl (CBP) or 1,3-bis(carbazole-9-yl) (mCP), and may be a phosphorescent material that includes a dopant containing any one or more selected from PIQIr(acac)(bis(1-phenylisoquinoline)acetylacetonate iridium), PQIr(acac)(bis(1-phenylquinoline)acetylacetonate iridium), PQIr(tris(1-phenylquinoline)iridium) and PtOEP(octaethylporphyrin platinum). In another embodiment, the organic material layer of the first light emitting layer of the first light emission area may be a fluorescent material that includes PBD:Eu(DBM)$_3$(Phen) or Perylene, but is not limited thereto.

The organic material layer of the second light emitting layer of the second light emission area for emitting light of a second color may include a host material that includes CBP or mCP, and may be a phosphorescent material that includes a dopant material containing Ir(ppy)3(fac tris(2-phenylpyridine)iridium). In another embodiment, the organic material layer of the second light emitting layer of the second light emission area for emitting light of a second color may be a fluorescent material that includes Alq3(tris(8-hydroxyquinolino)aluminium), but is not limited thereto.

The organic material layer of the light emitting layer of the third light emission area for emitting light of a third color may include a host material that includes CBP or mCP, and may be a phosphorescent material that includes a dopant material containing (4,6-F2ppy)2Irpic or L2BD111, but is not limited thereto.

The common electrode CM may be disposed on the first, second and third light emitting layers (e.g., EL). The common electrode CM may be disposed to cover the first, second and third light emitting layers. The common electrode CM may be a common layer commonly formed in the first to third light emitting layers. A capping layer may be formed on the common electrode CM.

In the top emission structure, the common electrode CM may be formed of a transparent conductive material (TCO) such as ITO and IZO, which may transmit light, or a semi-transmissive conductive material such as magnesium (Mg), silver (Ag) or an alloy of magnesium (Mg) and silver (Ag). In the case that the common electrode CM is formed of a semi-transmissive conductive material, light output efficiency may be enhanced by a micro cavity.

The encapsulation layer ENC may be formed on the light emitting element layer EMTL. The encapsulation layer ENC may include at least one inorganic layer TFE1 or TFE3 to prevent oxygen or moisture from being permeated into the light emitting element layer EMTL. The encapsulation layer ENC may include at least one organic layer to protect the light emitting element layer EMTL from particles such as dust. For example, the encapsulation layer ENC may include a first encapsulation inorganic layer TFE1, an encapsulation organic layer TFE2 and a second encapsulation inorganic layer TFE3.

The first encapsulation inorganic layer TFE1 may be disposed on the common electrode CM, the encapsulation organic layer TFE2 may be disposed on the first encapsulation inorganic layer TFE1, and the second encapsulation inorganic layer TFE3 may be disposed on the encapsulation organic layer TFE2. The first encapsulation inorganic layer TFE1 and the second encapsulation inorganic layer TFE3 may be formed of a multi-layer in which one or more inorganic layers of a silicon nitride layer, a silicon oxynitride layer, a silicon oxide layer, a titanium oxide layer and an aluminium oxide layer are stacked on each other. The encapsulation organic layer TFE2 may be an organic layer such as an acryl resin, an epoxy resin, a phenolic resin, a polyamide resin and/or a polyimide resin.

According to the embodiment shown in FIGS. 6A to 20, the third lower capacitor electrode C3a has a structure that may connect the first common node CN1 with the second common node CN2 and thus may have a wide area as much as the connection path. The third upper capacitor electrode C3b disposed to face the third lower capacitor electrode C3a having the above structure overlaps the third lower capacitor electrode C3a, and thus the third lower capacitor electrode C3a may also have a wide area as much as the connection path described above. Therefore, an overlap area between the third lower capacitor electrode C3a and the third upper capacitor electrode C3b may be increased, so that the capacity of the third capacitor C3 may be increased. As the capacity of the third capacitor C3 is increased, the kickback voltage Vkb (e.g., the kickback voltage of the first common node CN1 or the kickback voltage of the second common node CN2) of the dual gate transistor may be reduced as defined in Equation 1 below:

$$[\text{Equation 1}]$$

$$\text{Vkb} = \{\text{Cgs}/(\text{Cgs}+\text{Cnode})\}*(\text{VGH}-\text{VGL})$$

In the above Equation 1, Cgs may refer to a capacity of a parasitic capacitor between a gate electrode and a source electrode of a dual gate transistor (e.g., the third transistor T3 or the fourth transistor T4), Cnode may refer to the capacity of the third capacitor C3, and VGH may refer to a high potential voltage of a gate signal (e.g., the second gate signal or the third gate signal) applied to the gate electrode of the dual gate transistor (e.g., the third transistor T3 or the fourth transistor T4). VGL may refer to a low potential voltage of the gate signal (e.g., the second gate signal or the third gate signal) applied to the gate electrode of the dual gate transistor (e.g., the third transistor T3 or the fourth transistor T4).

According to the Equation 1 above, since the kickback voltage Vkb is inversely proportional to the capacity of the third capacitor C3, an increase in the capacity of the third capacitor C3 due to an increase in the area of the third lower capacitor electrode C3a may lead to a decrease in the kickback voltage Vkb.

The source-drain voltage of the dual gate transistor may be reduced in accordance with a decrease of the kickback voltage Vkb, and its decrease may reduce an off-leakage current of the dual gate transistor. As a result, the third lower capacitor electrode C3a having a structure for connecting the first common node CN1 of the third transistor T3 with the second common node CN2 of the fourth transistor T4 may have a wider area, whereby the capacity of the third capacitor C3 may be increased and thus the off-leakage current of the dual gate transistor may be reduced.

Moreover, since low frequency flicker may be improved in accordance with the decrease in the off-leakage current of the dual gate transistor, the display device may be driven without flicker even at a lower frequency (e.g., about 30Hz). For example, in the case that the off-leakage current of the (3-1)th transistor T3-1, the (3-2)th transistor T3-2, the (4-1)th transistor T4-1 and the (4-2)th transistor T4-2, which are connected to the third node N3, is reduced, voltage variation of the first capacitor C1 connected to the third node N3 may be minimized, whereby low frequency driving characteristics of the display device 10 may be improved. Therefore, the disclosure may be advantageously applied to, for example, a small and medium-sized information technology (IT) or a small and medium-sized mobile display device.

As described above, since the first lower capacitor electrode C3a of the third capacitor C3 may have a wide area, light from the outside (e.g., light from the bottom of the substrate) may be more effectively shielded.

According to an embodiment shown in FIGS. 6A to 20, the first electrode (e.g., the third lower capacitor electrode C3a) of the third capacitor C3 may be supplied with the first initialization voltage through the (4-2)th transistor T4-2, and the second electrode (e.g., the third upper capacitor electrode C3b) of the third capacitor C3 may be supplied with the first driving voltage through the first driving voltage line VDL.

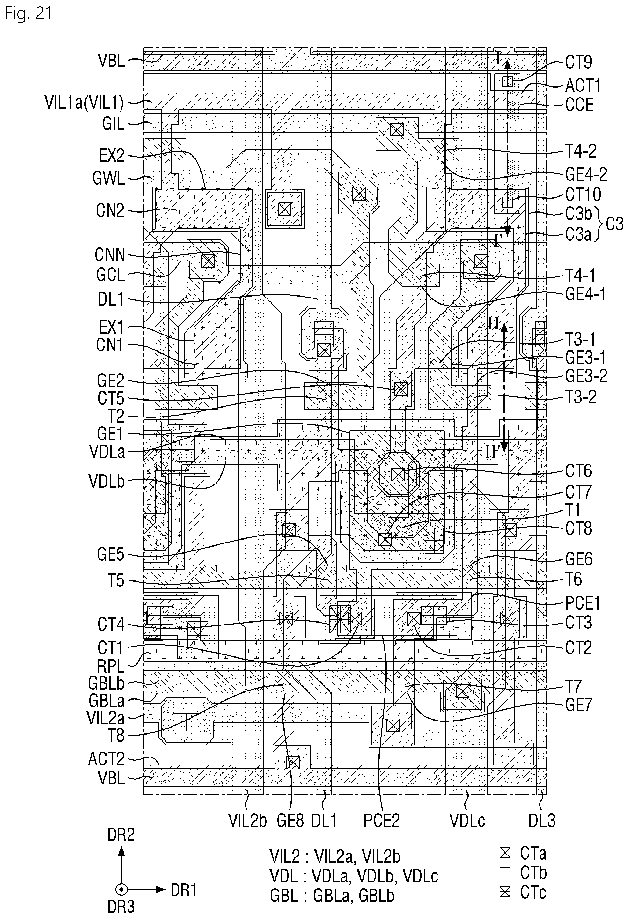

The second electrode of the third capacitor C3 may be supplied with another direct current voltage instead of the first driving voltage. This will be described below with reference to FIGS. 21 to 26.

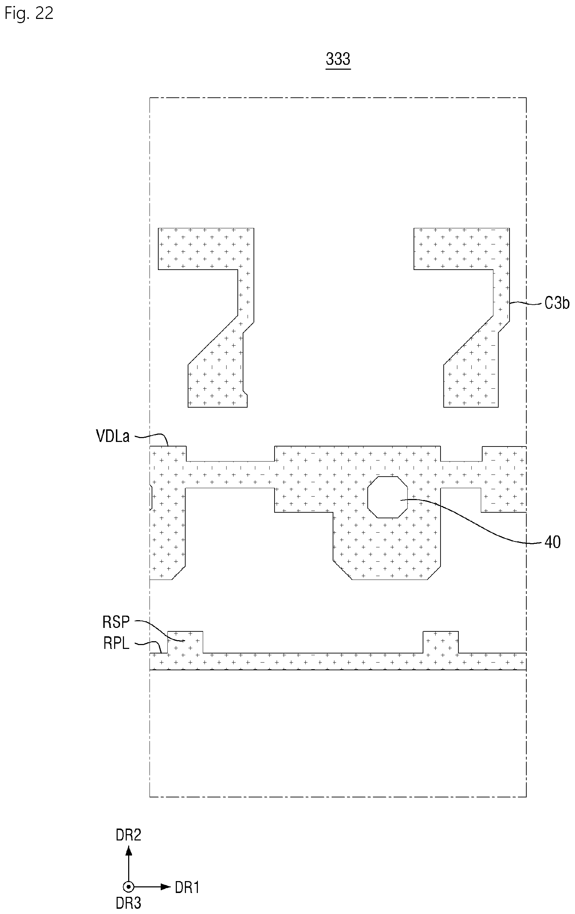

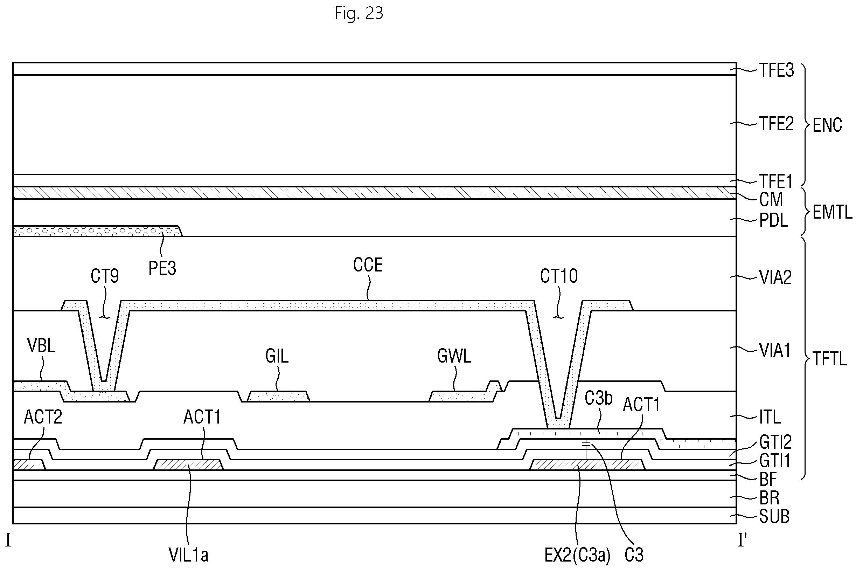

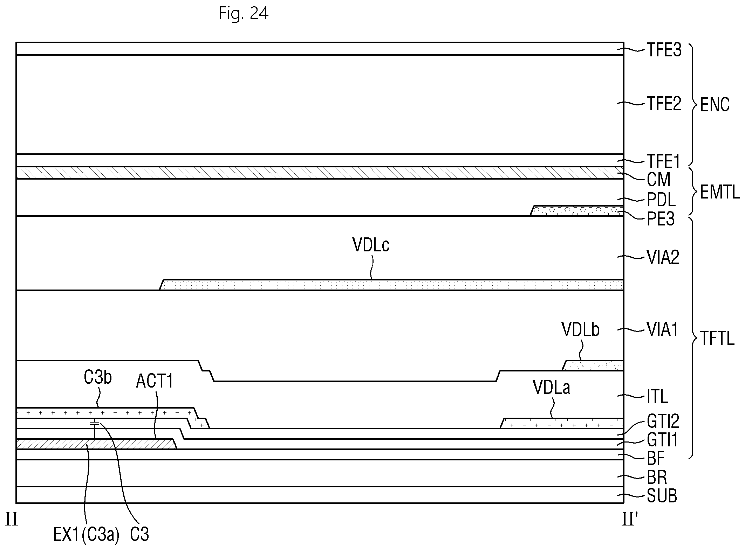

FIG. 21 is a schematic plan view illustrating a pixel array of a display device according to an embodiment. FIG. 22 is a schematic plan view selectively illustrating only a third conductive layer 333 of elements of FIG. 21. FIG. 23 is a schematic cross-sectional view taken along line I-I' of FIG. 21. FIG. 24 is a schematic cross-sectional view taken along line II-II' of FIG. 21.

As shown in FIGS. 21 and 24, the third upper capacitor electrode C3b may receive, for example, the bias voltage instead of the first driving voltage as the direct current voltage. To this end, for example, the bias voltage line VBL and the third upper capacitor electrode C3b may be connected to each other through a capacitor connection electrode CCE.

The capacitor connection electrode CCE may be made of, for example, the same material as that of the fifth conductive layer 555 described above. For example, the capacitor connection electrode CCE may be made of the same material as that of the first data line DL1, and may be disposed on the same layer as the first data line DL1. In other words, as shown in FIG. 21, the capacitor connection electrode CCE may be disposed on the first planarization layer VIA1.

A side of the capacitor connection electrode CCE may be connected to the bias voltage line VBL through a ninth contact hole CT9 passing through the first planarization layer VIA1, as shown in FIGS. 23 and 24. Another side of the capacitor connection electrode CCE may be connected to the third upper capacitor electrode C3b through a tenth contact hole CT10 passing through the first planarization layer VIA1 and the interlayer insulating layer ITL. As shown in FIGS. 21, 22 and 24, the third upper capacitor electrode C3b and the first lower driving voltage line VDLa may not be electrically connected to each other. In other words, as shown in FIGS. 22 and 24, the third upper capacitor electrode C3b and the first lower driving voltage line VDLa may be separated from each other. Therefore, only the bias voltage that is not the first driving voltage may be applied to the third upper capacitor electrode C3b.

Each of the ninth contact hole CT9 and the tenth contact hole CT10 may correspond to the second type contact hole CTb.

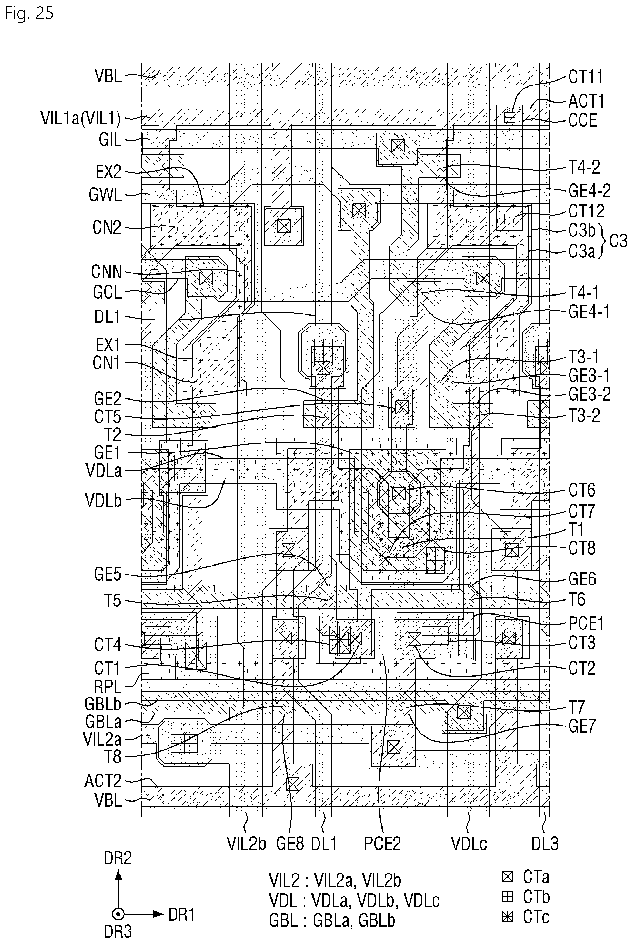

FIG. 25 is a schematic plan view illustrating a pixel array of a display device according to an embodiment.

As shown in FIG. 25, the third upper capacitor electrode C3b may receive, for example, the first initialization voltage instead of the first driving voltage as the direct current voltage. To this end, for example, the first lower initialization voltage line VIL1a and the third upper capacitor electrode C3b may be connected to each other through the capacitor connection electrode CCE.

The capacitor connection electrode CCE may be made of, for example, the same material as that of the fifth conductive layer 555 described above. For example, the capacitor connection electrode CCE may be made of the same material as that of the first data line DL1, and may be disposed on the same layer as the first data line DL1. In other words, the capacitor connection electrode CCE may be disposed on the first planarization layer VIA1. A side of the capacitor connection electrode CCE may be connected to the first lower initialization voltage line VIL1a through an eleventh contact hole CT11 passing through the first planarization layer VIA1, the interlayer insulating layer ITL, the second gate insulating layer GTI1 and the first gate insulating layer GTI1, as shown in FIGS. 23 and 24. Another side of the capacitor connection electrode CCE may be connected to the third upper capacitor electrode C3b through a twelfth contact hole CT12 passing through the first planarization layer VIA1 and the interlayer insulating layer ITL. As shown in FIGS. 21, 22 and 24, the third upper capacitor electrode C3b and the first lower driving voltage line VDLa may not be electrically connected to each other. In other words, as shown in FIGS. 22 and 24, the third upper capacitor electrode C3b and the first lower driving voltage line VDLa may be separated from each other. Therefore, only the first initialization voltage that is not the first driving voltage may be applied to the third upper capacitor electrode C3b.

Each of the eleventh contact hole CT11 and the twelfth contact hole CT12 may correspond to the second type contact hole CTb.

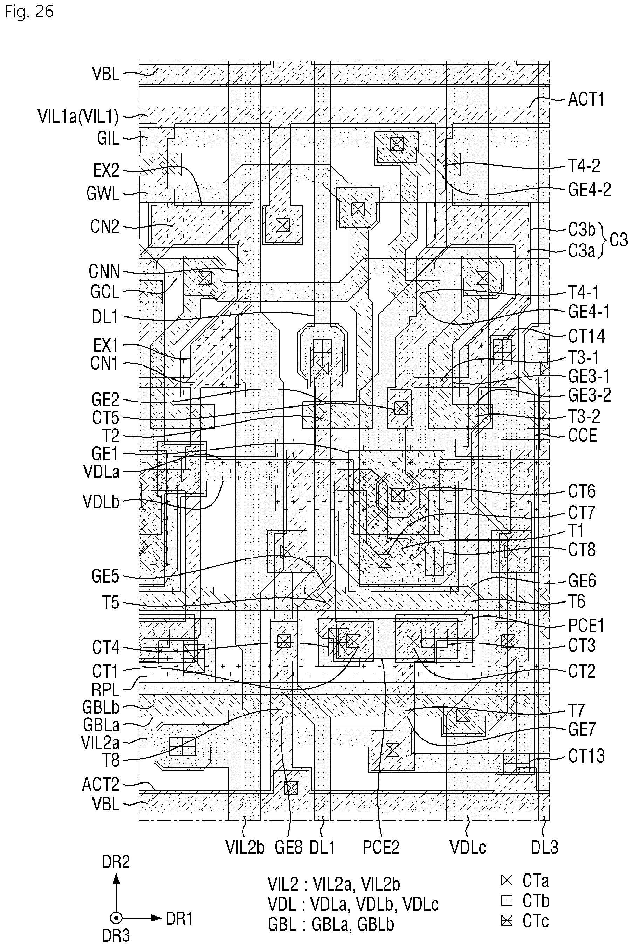

FIG. 26 is a schematic plan view illustrating a pixel array of a display device according to an embodiment.

As shown in FIG. 26, the third upper capacitor electrode C3b may receive, for example, the second initialization voltage instead of the first driving voltage as the direct current voltage. To this end, for example, the second lower initialization voltage line VIL2a and the third upper capacitor electrode C3b may be connected to each other through the capacitor connection electrode CCE.

The capacitor connection electrode CCE may be made of, for example, the same material as that of the fifth conductive layer 555 described above. For example, the capacitor connection electrode CCE may be made of the same material as that of the first data line DL1, and may be disposed on the same layer as the first data line DL1. In other words, the capacitor connection electrode CCE may be disposed on the first planarization layer VIA1. A side of the capacitor connection electrode CCE may be connected to the second lower initialization voltage line VIL2a through a thirteenth contact hole CT13 passing through the first planarization layer VIA1, as shown in FIG. 26. Another side of the capacitor connection electrode CCE may be connected to the third upper capacitor electrode C3b through a fourteenth contact hole CT14 passing through the first planarization layer VIA1 and the interlayer insulating layer ITL. As shown in FIGS. 21, 22 and 24, the third upper capacitor electrode C3b and the first lower driving voltage line VDLa may not be electrically connected to each other. In other words, as shown in FIGS. 22 and 24, the third upper capacitor electrode C3b and the first lower driving voltage line VDLa may be separated from each other. Therefore, only the second initialization voltage that is not the first driving voltage may be applied to the third upper capacitor electrode C3b.

Each of the thirteenth contact hole CT13 and the fourteenth contact hole CT14 may correspond to the second type contact hole CTb.

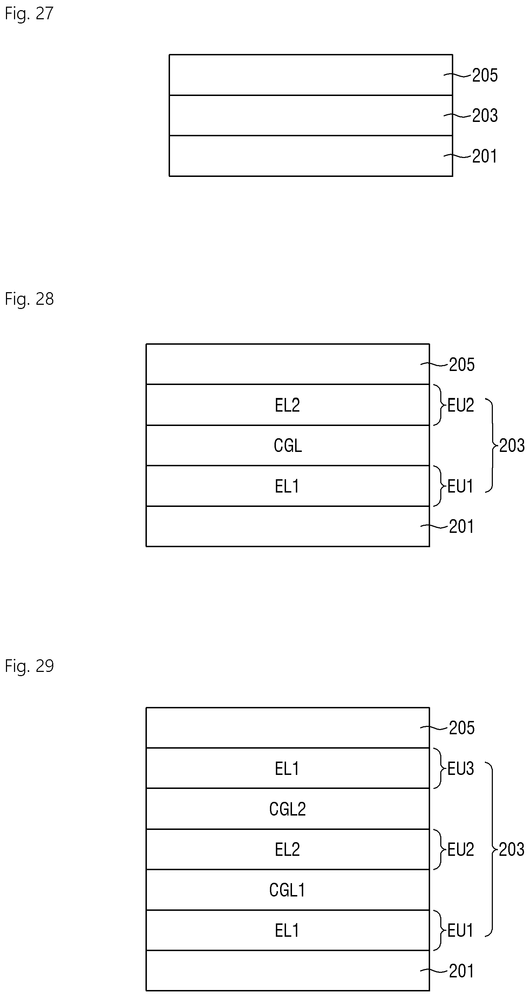

Another structure of the light emitting element (e.g., LEL in FIG. 18) will be described with reference to FIGS. 27 to 34.

FIG. 27 is a schematic cross-sectional view illustrating a structure of a display element according to an embodiment. FIGS. 28 to 31 are schematic cross-sectional views illustrating a structure of a light emitting element according to an embodiment.

Referring to FIG. 27, a light emitting element (e.g., an organic light emitting diode) according to an embodiment may include a pixel electrode 201, a common electrode 205 and an intermediate layer 203 between the pixel electrode 201 and the common electrode 205.

The pixel electrode 201 may include a transparent conductive oxide, which is light-transmissive, such as indium tin oxide (ITO), indium zinc oxide (IZO), zinc oxide (ZnO), indium oxide ($In_2O_3$), indium gallium oxide (IGO) and/or aluminium zinc oxide (AZO). The pixel electrode 201 may include a reflective layer that includes silver (Ag), magnesium (Mg), aluminium (Al), platinum (Pt), palladium (Pd), gold (Au), nickel (Ni), neodymium (Nd), iridium (Ir), chromium (Cr) and/or a compound thereof. For example, the pixel electrode 201 may have a three-layer structure of ITO/Ag/ITO.

The common electrode 205 may be disposed on the intermediate layer 203. The common electrode 205 may include a metal having a low work function, an alloy, an electrically conductive compound or any combination thereof. For example, the common electrode 205 may include Li, Ag, Mg, Al, Al-Li, Ca, Mg-In, Mg-Ag, Yb, Ag-Yb, ITO, IZO or any combination thereof. The common electrode 205 may be a transmissive electrode, a semi-transmissive electrode and/or a reflective electrode.

The intermediate layer 203 may include a polymer or a low molecular weight organic material, which emits light of a predetermined or selected color. The intermediate layer 203 may further include a metal-containing compound such as an organo-metallic compound, an inorganic material such as a quantum dot and the like in addition to various organic materials.

In an embodiment, the intermediate layer 203 may include a light emitting layer, and first and second functional layers respectively disposed below and above the light emitting layer. The first functional layer may include, for example, a hole transporting layer HTL, or may include a hole transporting layer and a hole injection layer HIL. The second functional layer may be an element disposed above the light emitting layer, and is optional. For example, the intermediate layer 203 may include the second functional layer or not. The second functional layer may include an electron transporting layer ETL and/or an electron injection layer EIL.

In an embodiment, the intermediate layer 203 may include two or more emitting units stacked on each other between the pixel electrode 201 and the common electrode 205, and a charge generation layer CGL disposed between the two light emitting units. In the case that the intermediate layer 203 includes a light emitting unit and a charge generation layer, the light emitting element (e.g., the organic light emitting diode) may be a tandem light emitting element. The light emitting element (e.g., the organic light emitting diode) may have a stacked structure of multiple light emitting units, thereby improving color purity and light emitting efficiency.

A light emitting unit may include a light emitting layer and first and second functional layers respectively disposed below and above the light emitting layer. The charge generation layer CGL may include a negative charge generation layer and a positive charge generation layer. The light emitting efficiency of the organic light emitting diode, which is a tandem light emitting element having multiple light emitting layers, may be increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply a hole. The positive charge generation layer may include a host and a dopant. The host may include an organic material. The dopant may include a metal material.

In an embodiment, as shown in FIG. 28, the light emitting element (e.g., the organic light emitting diode) may include a first light emitting unit EU1 and a second light emitting unit EU2 that are stacked on each other, wherein the first light emitting unit EU1 includes a first light emitting layer EL1 and the second light emitting unit EU2 includes a second light emitting layer EL2. The charge generation layer CGL may be disposed between the first light emitting unit EU1 and the second light emitting unit EU2. For example, the light emitting element (e.g., the organic light emitting diode) may include a pixel electrode 201, a first light emitting layer EL1, a charge generation layer CGL, a second light emitting layer EL2 and a common electrode 205, which are stacked on each other. The first functional layer and the second functional layer may be respectively disposed below and above the first light emitting layer EL1. The first functional layer and the second functional layer may be respectively included below and above the second light emitting layer EL2. The first light emitting layer EL1 may be a blue light emitting layer, and the second light emitting layer EL2 may be a yellow light emitting layer.

In an embodiment, as shown in FIG. 29, the light emitting element (e.g., the organic light emitting diode) may include first and third light emitting units EU1 and EU3 including a first light emitting layer EL1, and a second light emitting unit EU2 including a second light emitting layer EL2. A first charge generation layer CGL1 may be disposed between the first light emitting unit EU1 and the second light emitting unit EU2, and a second charge generation layer CGL2 may be disposed between the second light emitting unit EU2 and the third light emitting unit EU3. For example, the light emitting element (e.g., the organic light emitting diode) may include a pixel electrode 201, a first light emitting layer EL1, a first charge generation layer CGL, a second light emitting layer EL2, a second charge generation layer CGL2, a first light emitting layer EL1 and a common electrode 205, which are stacked on each other. The first functional layer and the second functional layer may be respectively disposed below and above the first light emitting layer EL1. The first functional layer and the second functional layer may be respectively disposed below and above the second light emitting layer EL2. The first light emitting layer EL1 may be a blue light emitting layer, and the second light emitting layer EL2 may be a yellow light emitting layer.

In an embodiment, the second light emitting unit EU2 of the light emitting element (e.g., the organic light emitting diode) may further include a third light emitting layer EL3 and/or a fourth light emitting layer EL4, which are directly in contact with the second light emitting layer EL2, below and/or above the second light emitting layer EL2, in addition to the second light emitting layer EL2. Direct contact may mean that another layer is not disposed between the second light emitting layer EL2 and the third light emitting layer EL3 and/or between the second light emitting layer EL2 and the fourth light emitting layer EL4. The third light emitting layer EL3 may be a red light emitting layer, and the fourth light emitting layer EL4 may be a green light emitting layer.

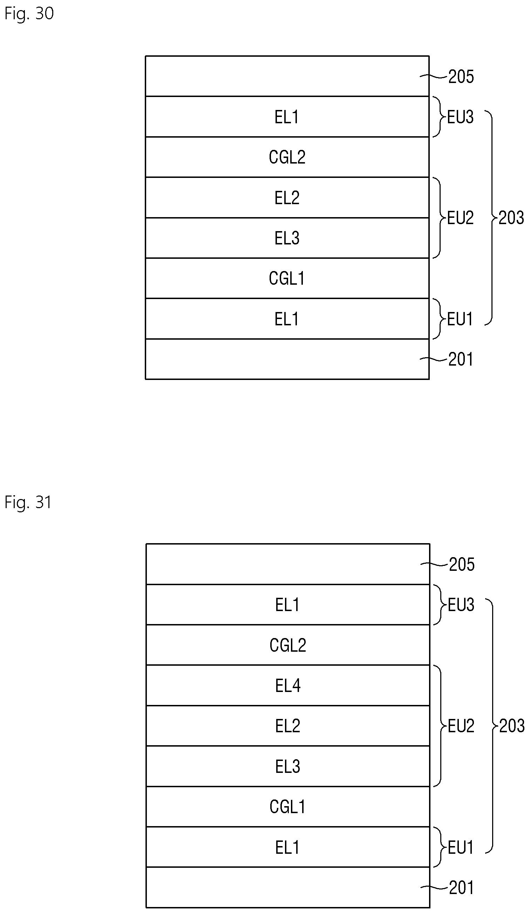

For example, as shown in FIG. 30, the light emitting element (e.g., the organic light emitting diode) may include a pixel electrode 201, a first light emitting layer EL1, a first charge generation layer CGL1, a third light emitting layer EL3, a second light emitting layer EL2, a second charge generation layer CGL2, a first light emitting layer EL1 and a common electrode 205, which are stacked on each other. In another embodiment, as shown in FIG. 31, the light emitting element (e.g., the organic light emitting diode) may include a pixel electrode 201, a first light emitting layer EL1, a first charge generation layer CGL1, a third light emitting layer EL3, a second light emitting layer EL2, a fourth light emitting layer EL4, a second charge generation layer CGL2, a first light emitting layer EL1 and a common electrode 205, which are stacked on each other.

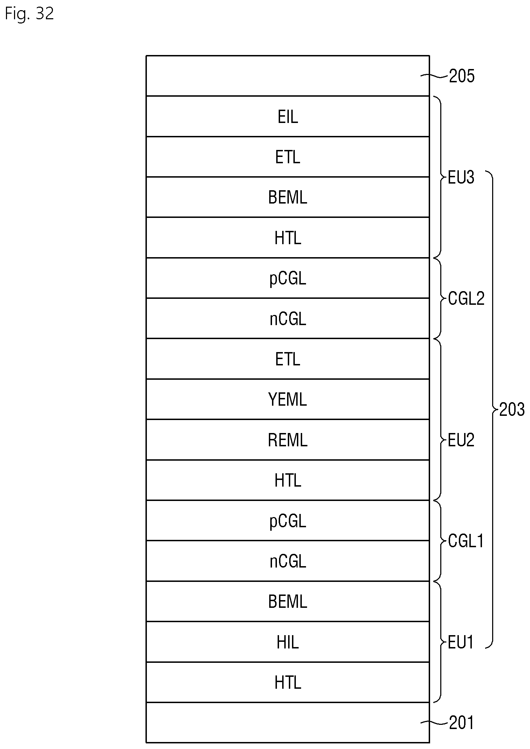

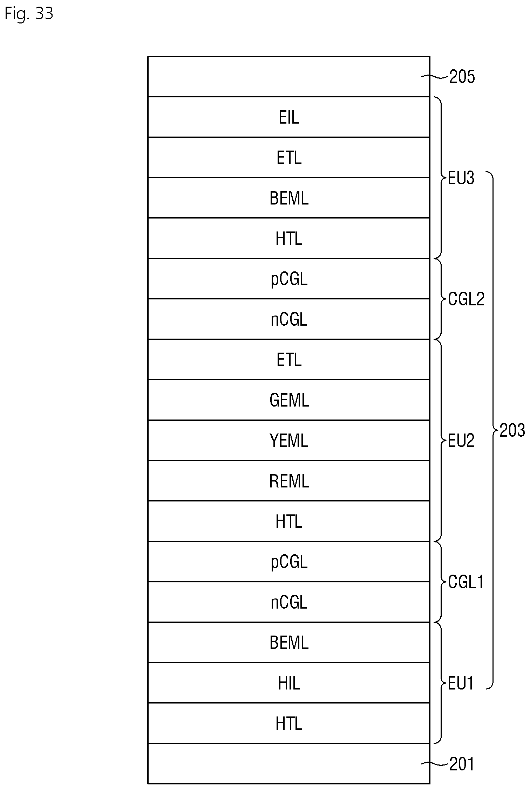

FIG. 32 is a schematic cross-sectional view illustrating an example of the organic light emitting diode of FIG. 30, and FIG. 33 is a schematic cross-sectional view illustrating an example of the organic light emitting diode of FIG. 31.

Referring to FIG. 32, the light emitting element (e.g., the organic light emitting diode) may include a first light emitting unit EU1, a second light emitting unit EU2 and a third light emitting unit EU3, which are stacked on each other. The first charge generation layer CGL 1 may be disposed between the first light emitting unit EU1 and the second light emitting unit EU2, and the second charge generation layer CGL2 may be disposed between the second light emitting unit EU2 and the third light emitting unit EU3. The first charge generation layer CGL1 and the second charge generation layer CGL2 may include a negative charge generating layer nCGL and a positive charge generating layer pCGL, respectively.

The first light emitting unit EU1 may include a blue light emitting layer BEML. The first light emitting unit EU1 may further include a hole injection layer HIL and a hole transporting layer HTL between the pixel electrode 201 and the blue light emitting layer BEML. In an embodiment, a p-doping layer may be further included between the hole injection layer HIL and the hole transporting layer HTL. The p-type doping layer may be formed by doping the hole injection layer HIL with a p-type doping material. In an embodiment, at least one of a blue light auxiliary layer, an electron blocking layer, and a buffer layer may be further included between the blue light emitting layer BEML and the hole transporting layer HTL. The blue light auxiliary layer may enhance light emitting efficiency of the blue light emitting layer BEML. The blue light auxiliary layer may adjust a hole charge balance to enhance light emitting efficiency of the blue light emitting layer. The electron blocking layer may prevent electron injection into the hole transporting layer HTL. The buffer layer may compensate for a resonance distance according to a wavelength of light emitted from the light emitting layer.

The second light emitting unit EU2 may include a yellow light emitting layer YEML and a red light emitting layer REML that is directly in contact with the yellow light emitting layer YEML below the yellow light emitting layer YEML. The second light emitting unit EU2 may further include a hole transporting layer HTL between the positive charge generation layer pCGL of the first charge generation layer CGL1 and the red light emitting layer REML, and may further include an electron transporting layer ETL between the yellow light emitting layer YEML and the negative charge generation layer nCGL of the second charge generation layer CGL2.

The third light emitting unit EU3 may include a blue light emitting layer BEML. The third light emitting unit EU3 may further include a hole transporting layer HTL between the positive charge generation layer pCGL of the second charge generation layer CGL2 and the blue light emitting layer BEML. The third light emitting unit EU3 may further include an electron transporting layer ETL and an electron injection layer EIL between the blue light emitting layer BEML and the common electrode 205. The electron transporting layer ETL may be a single layer or multi-layer. In an embodiment, at least one of the blue light auxiliary layer, the electron blocking layer, and the buffer layer may be further included between the blue light emitting layer BEML and the hole transporting layer HTL. At least one of a hole blocking layer and a buffer layer may be further included between the blue light emitting layer BEML and the electron transporting layer ETL. The hole blocking layer may prevent hole injection into the electron transporting layer ETL.

The light emitting element (e.g., the organic light emitting diode) shown in FIG. 33 may be different from the light emitting element (e.g., the organic light emitting diode shown in FIG. 32) at least in the stacked structure of the second light emitting unit EU2, but may be the same as the light emitting element (e.g., the organic light emitting diode shown in FIG. 32) in other elements. Referring to FIG. 33, the second light emitting unit EU2 may include a yellow light emitting layer YEML, a red light emitting layer REML that is directly in contact with the yellow light emitting layer YEML below the yellow light emitting layer YEML, and a green light emitting layer GEML that is directly in contact with the yellow light emitting layer YEML above the yellow light emitting layer YEML. The second light emitting unit EU2 may further include a hole transporting layer HTL between the positive charge generation layer pCGL of the first charge generation layer CGL1 and the red light emitting layer REML, and may further include an electron transporting layer ETL between the green light emitting layer GML and the negative charge generation layer nCGL of the second charge generation layer CGL2.

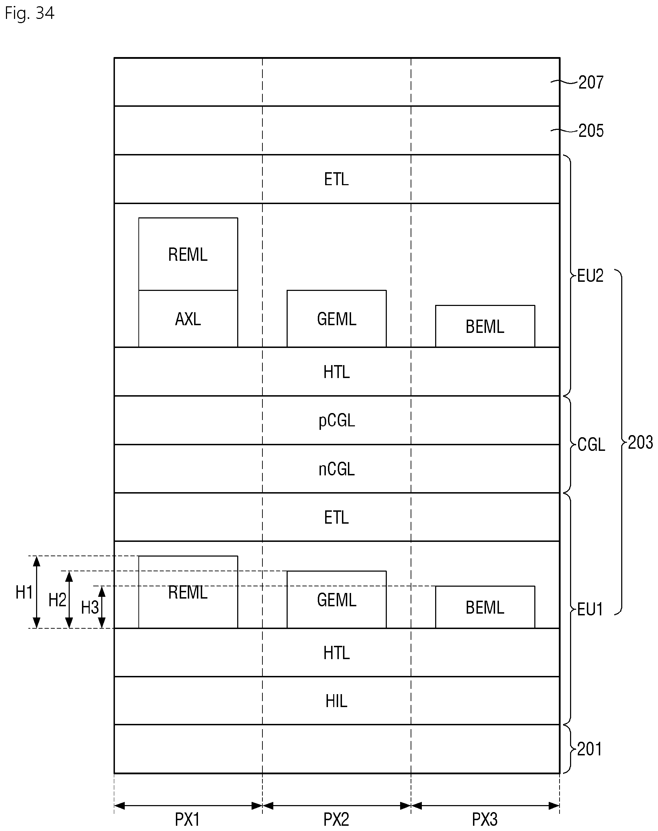

FIG. 34 is a schematic cross-sectional view illustrating a structure of a pixel of a display device according to an embodiment of the disclosure.

Referring to FIG. 34, a display panel 100 of the display device 10 may include pixels (e.g., subpixels described above). The pixels may include a first pixel PX1, a second pixel PX2 and a third pixel PX3. Each of the first pixel PX1, the second pixel PX2 and the third pixel PX3 may include a pixel electrode 201, a common electrode 205 and an intermediate layer 203. In an embodiment, the first pixel PX1 may be a red pixel, the second pixel PX2 may be a green pixel, and the third pixel PX3 may be a blue pixel.

The pixel electrode 201 may be independently provided in each of the first pixel PX1, the second pixel PX2 and the third pixel PX3.

The intermediate layer 203 of each of the first pixel PX1, the second pixel PX2 and the third pixel PX3 may include first and second light emitting units EU1 and EU2, which are stacked on each other, and a charge generation layer CGL between the first light emitting unit EU1 and the second light emitting unit EU2. The charge generation layer CGL may include a negative charge generation layer nCGL and a positive charge generation layer pCGL. The charge generation layer CGL may be a common layer continuously formed in the first pixel PX1, the second pixel PX2 and the third pixel PX3.

The first light emitting unit EU1 of the first pixel PX1 may include a hole injection layer HIL, a hole transporting layer HTL, a red light emitting layer REML and an electron transporting layer ETL, which are stacked on each other on the pixel electrode 201. The first light emitting unit EU1 of the second pixel PX2 may include a hole injection layer HIL, a hole transporting layer HTL, a green light emitting layer GEML and an electron transporting layer ETL, which are stacked on each other on the pixel electrode 201. The first light emitting unit EU1 of the third pixel PX3 may include a hole injection layer HIL, a hole transporting layer HTL, a blue light emitting layer BEML and an electron transporting layer ETL, which are stacked on each other on the pixel electrode 201. Each of the hole injection layer HIL, the hole transporting layer HTL and the electron transporting layer ETL of the first light emitting unit EU1 may be a common layer continuously formed in the first pixel PX1, the second pixel PX2 and the third pixel PX3. The second light emitting unit EU2 of the first pixel PX1 may include a hole transporting layer HTL, an auxiliary layer AXL, a red light emitting layer REML and an electron transporting layer ETL, which are stacked on each other on the charge generation layer CGL. The second light emitting unit EU2 of the second pixel PX2 may include a hole transporting layer HTL, a green light emitting layer GEML and an electron transporting layer ETL, which are stacked on each other on the charge generation layer CGL. The second light emitting unit EU2 of the third pixel PX3 may include a hole transporting layer HTL, a blue light emitting layer BEML and an electron transporting layer ETL, which are stacked on each other on the charge generation layer CGL. Each of the hole transporting layer HTL and the electron transporting layer ETL of the second light emitting unit EU1 may be a common layer continuously formed in the first pixel PX1, the second pixel PX2 and the third pixel PX3. In an embodiment, at least one of a hole blocking layer and a buffer layer may be further included between the light emitting layer and the electron transporting layer ETL in the second light emitting unit EU2 of the first pixel PX1, the second pixel PX2 and the third pixel PX3.

A thickness H1 of the red light emitting layer REML, a thickness H2 of the green light emitting layer GML and a thickness H3 of the blue light emitting layer BEML may be determined in accordance with a resonance distance. The auxiliary layer AXL may be a layer added to match the resonance distance, and may include a resonance assistance material. For example, the auxiliary layer AXL may include the same material as that of the hole transporting layer HTL.

In FIG. 34, the auxiliary layer AXL is disposed only in the first pixel PX1, but the embodiments of the disclosure are not limited thereto. For example, the auxiliary layer AXL may be disposed in at least one of the first pixel PX1, the second pixel PX2 and the third pixel PX3 in order to match the resonance distance of each of the first pixel PX1, the second pixel PX2 and the third pixel PX3.

The display panel 100 of the display device 10 may further include a capping layer 207 disposed outside the common electrode 205. The capping layer 207 may serve to improve light emitting efficiency by the principle of constructive interference. Therefore, light extraction efficiency of the light emitting element (e.g., the organic light emitting diode) may be increased so that light emitting efficiency of the light emitting element (e.g., the organic light emitting diode) may be improved.

The pixel circuit (e.g., the first pixel circuit PC1) of the disclosure may include, for example, more than two composite gate transistors. For example, the pixel circuit of the disclosure may further include another dual gate transistor (e.g., a ninth transistor) in addition to the third transistor T3 and the fourth transistor T4, which are dual gate transistors. The ninth transistor may include sub-transistors connected in series through a third common node. The aforementioned third lower capacitor electrode C3a may connect the first common node CN1 of the third transistor T3, the second common node CN2 of the fourth transistor T4 and the third common node of the ninth transistor to one another.

The composite gate transistor of the disclosure may include, for example, more than two sub-transistors. For example, the third transistor T3 may include a (3-1)th transistor T3-1, a (3-2)th transistor T3-2 having a source electrode connected to a drain electrode of the (3-1)th transistor T3-1, and a (3-3)th transistor having a source electrode connected to a drain electrode of the (3-2)th transistor T3-2.

Instead of the third upper capacitor electrode C3b, for example, a capacitor electrode disposed to be closer to the substrate SUB than the third lower capacitor electrode C3b may be used. In other words, the aforementioned capacitor electrode may be disposed at a side lower than the third lower capacitor electrode C3a in a direction opposite to the third direction DR3, and thus this capacitor electrode may overlap the third lower capacitor electrode C3a to form the third capacitor C3. For example, the capacitor electrode may be disposed between the barrier layer BR and the buffer layer BF so as to overlap the aforementioned third lower capacitor electrode C3a. The aforementioned capacitor electrode may be connected to any one of the first driving voltage line VDL (e.g., the first lower driving voltage line VDLa), the second driving voltage line VSL, the first initialization voltage line VIL1 (e.g., the first lower initialization voltage line VIL1a), the second initialization voltage line VIL2 (e.g., the second lower initialization voltage line VIL2a) and the bias voltage line VBL through the contact hole of the insulating layer.

The aforementioned capacitor electrode may be made of the same material as that of any one of the first to fifth conductive layers.

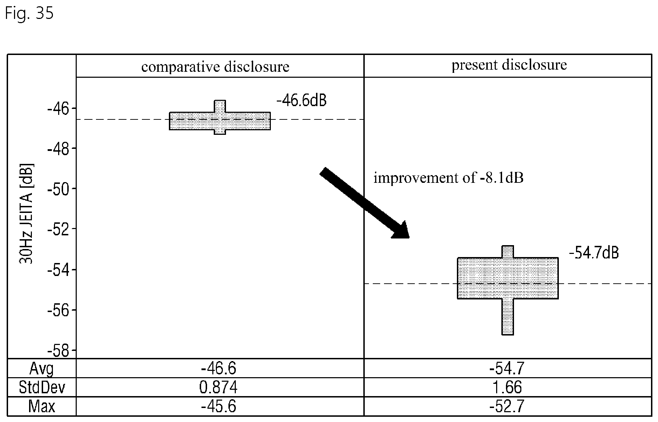

FIG. 35 is a schematic view illustrating an effect of the disclosure.

As shown in FIG. 35, according to the display device 10, which includes the structure (the third capacitor C3 that includes the third lower capacitor electrode C3a connecting common nodes (e.g., CN1 and CN2) between the dual gate transistors and the third upper capacitor electrode C3b overlapped with the third lower capacitor electrode C3a) of the disclosure, the kickback voltage of the common node may be reduced and thus low frequency driving is possible.

According to the flicker experimental result defined in Japan Electronics and Information Technology Industries Association (JEITA), as compared with a comparative disclosure to which the structure of the disclosure is not applied, the display device of the disclosure may have a low flicker value of about -54.7[dB] on average even during low frequency driving (e.g., about 30Hz). Therefore, the display device of the disclosure may have a flicker value lower than that of the comparative disclosure as much as about -8.1[dB]. Therefore, the display device of the disclosure may not degrade image quality even during low frequency driving. The display device of the disclosure may have a flicker value of up to about -52.7[dB] during low frequency driving (e.g., about 30Hz), and may have a standard deviation value of about 1.66 [dB].

A person having ordinary skill in the technical field to which this specification pertains will understand that this specification can be implemented in other specific forms without changing its technical idea or essential characteristics. Therefore, it should be understood that the embodiments described above are exemplary in all respects and not restrictive. The scope of this specification is indicated by the scope of the patent claims described below rather than the detailed description above, and all changes or modifications derived from the meaning and scope of the scope of the patent claims and their equivalent concepts should be interpreted as being included in the scope of this specification. Meanwhile, this specification and drawings disclose preferred embodiments of this specification, and although specific terms are used, they are used only in a general sense to easily explain the technical contents of this specification and to help understand the invention, and are not intended to limit the scope of this specification. In addition to the embodiments disclosed herein, it is obvious to a person having ordinary skill in the technical field to which this specification pertains that other modified examples based on the technical idea of this specification are possible.

## Claims

1. A display device, comprising:

   a pixel electrode; and
   a pixel circuit electrically connected to the pixel electrode,
   wherein the pixel circuit includes:

   a first transistor including a plurality of sub-transistors electrically connected to each other through a first common node;
   a second transistor including a plurality of sub-transistors electrically connected to each other through a second common node;
a first electrode electrically connecting the first common node with the second common node; and
a second electrode disposed to overlap the first electrode and electrically connected to a direct current power source.

2. The display device of claim 1, wherein the first common node, the second common node, and the first electrode are integral with each other.

3. The display device of claim 1, wherein

a first sub-transistor of the first transistor and a second sub-transistor of the second transistor are electrically connected to each other through source electrodes and drain electrodes of the first sub-transistor of the first transistor and the second sub-transistor of the second transistor, and
the source electrode of the first sub-transistor, the drain electrode of the first sub-transistor, the first common node, the first electrode, the second common node, the source electrode of the second sub-transistor, and the drain electrode of the second sub-transistor are electrically connected to one another and form a closed loop shape.

4. The display device of claim 3, wherein the source electrode of the first sub-transistor, the drain electrode of the first sub-transistor, the first common node, the first electrode, the second common node, the source electrode of the second sub-transistor, and the drain electrode of the second sub-transistor have a closed loop shape surrounding at least a portion of a gate electrode of the first sub-transistor.

5. The display device of claim 1, wherein the first common node, the second common node, and the first electrode are formed of a semiconductor material.

6. The display device of claim 1, wherein the second electrode overlaps the entirety of the first electrode.

7. The display device of claim 1, wherein an area of the second electrode is wider than an area of the first electrode.

8. The display device of claim 1, wherein the first electrode and the second electrode have a same shape.

9. The display device of claim 1, wherein the first electrode includes:

a first extension portion extended from the first common node in a second direction intersecting a first direction;
a second extension portion extended from the second common node in the first direction; and
a connection portion electrically connecting the first extension portion with the second extension portion.

10. The display device of claim 9, wherein the connection portion includes at least one curved portion.

11. The display device of claim 9, wherein

a first sub-transistor of the first transistor and a second sub-transistor of the second transistor are electrically connected to each other through a source electrode and a drain electrode of the second sub-transistor, and
the source electrode of the first sub-transistor, the drain electrode of the first sub-transistor, the first common node, the first extension portion, the connection portion, the second extension portion, the second common node, the source electrode of the second sub-transistor, and the drain electrode of the second sub-transistor are electrically connected to one another and form a closed loop shape.

12. The display device of claim 1, further comprising:
a direct current power line electrically connecting the direct current power source with the second electrode.

13. The display device of claim 12, further comprising:
a first driving voltage line, a first initialization voltage line, a second initialization voltage line, and a bias voltage line which are electrically connected to the pixel circuit.

14. The display device of claim 13, wherein the direct current power line is one of the first driving voltage line, the first initialization voltage line, the second initialization voltage line, and the bias voltage line.

15. The display device of claim 14, wherein

the direct current power line is the first driving voltage line, and
the second electrode and the direct current power line are integral with each other.

16. The display device of claim 13, wherein the direct current power line is one of the first initialization voltage line, the second initialization voltage line, and the bias voltage line.

17. The display device of claim 16, wherein the second electrode and the first driving voltage line are separated from each other.

**18.** The display device of claim 16, further comprising: a connection electrode electrically connecting the direct current power line with the second electrode.

**19.** The display device of claim 18, wherein the connection electrode is disposed on a different layer from the direct current power line and the second electrode.

**20.** The display device of claim 18, further comprising:

a data line disposed to be adjacent to the first electrode,
wherein the connection electrode is disposed between the data line and a first upper driving voltage line of the first driving voltage line.

**21.** The display device of claim 20, wherein the connection electrode, the data line, and the first upper driving voltage line are disposed on a same layer.

**22.** The display device of claim 1, wherein the pixel circuit further includes:

a driving transistor electrically connected between the first driving voltage line and the pixel electrode; and
a first capacitor electrically connected between the first driving voltage line and a gate electrode of the driving transistor.

**23.** The display device of claim 22, wherein

a first sub-transistor of the first transistor and a second sub-transistor of the second transistor are electrically connected to each other through source electrodes and drain electrodes of the first sub-transistor of the first transistor and the second sub-transistor of the second transistor, and
a contact point of the first sub-transistor and the second sub-transistor is electrically connected to the gate electrode of the driving transistor.

**24.** The display device of claim 1, wherein

gate electrodes of the plurality of sub-transistors included in the first transistor are integral with each other, and
gate electrodes of the plurality of sub-transistors included in the second transistor are integral with each other.

**25.** The display device of claim 1, wherein a capacitor is disposed in an overlap area between the first electrode and the second electrode.

**26.** A display device, comprising:

a pixel electrode;
a plurality of composite gate transistors electrically connected to the pixel electrode;
a first electrode electrically connecting common nodes of at least two composite gate transistors to each other; and
a second electrode disposed to overlap the first electrode and electrically connected to a direct current power source.

**27.** The display device of claim 26, wherein each of the composite gate transistors includes a plurality of sub-transistors electrically connected to a corresponding common node of a corresponding composite gate transistor.

**28.** The display device of claim 26, wherein the common nodes of the plurality of composite gate transistors and the first electrode are integral with each other.

Fig. 1

10

200
400
500

DA  NDA
MA

100

SBA

300

DR3

DR2 ← → DR1

Fig. 2

Fig. 3

Fig. 4

Fig. 5

Fig. 6A

Fig. 6B

Fig. 7

111

ACT1  CN2  EX2

VIL1a(VIL1)

C3a

CNN

EX1

CN1

C2a

ACT2

DR2

DR3  DR1

Fig. 8

222

GE4-2

GE4-1

GE3-1

GE2

GE3-2

GE1

C1a

EML

GBLa

GE8    GE5    GE7    GE6

DR2

DR3 → DR1

Fig. 9

Fig. 10

444

DME

VBL

GIL

GWL

GCL

DCE

GCE1

VDLb

TCE

PCE1

GBLb

VIL2a

VBL

DR2
DR1
DR3

Fig. 11

555

PCE2

DL2    VDLc        VIL2b   DL1   PCE2   VDLc   DL3   VDLc  PCE2

DR2

DR3  →  DR1

Fig. 12

666

Fig. 13

111, 222

ACT1      T4-1 T3-1 T4-2 CN2 EX2

VIL1a(VIL1)
E421
E422

E411
E412

T2
E21

E22

C2a
E11
E12

E51
E52
T5

E71
E72

T8

ACT2       T1 T7

C3a
CNN
EX1
E311
E312
E321
E322
CN1
T3-2
C1a

E61
E62
T6

E81
E82

DR2
⊙→DR1
DR3

Fig. 14

111, 333

C3b  CN2  C3a

VIL1a(VIL1)

C3

VDLa

CN1

C2

VDLa

RSP

RPL

DR2

DR3 DR1

Fig. 15

111, 222, 333

CN2  T4-2  C3a

C3b

T4-1

T3-1

CN1

T3-2

C2

C1

DR2

DR1

DR3

Fig. 16

VBL

VIL1a(VIL1)

GIL

EX2

GWL

CN2

CNN

GCL

DL1

EX1

CN1

GE2

CT5

T2

GE1

VDLa

VDLb

GE5

T5

CT4

CT1

RPL

GBLb

GBLa

VIL2a

T8

ACT2

VBL

ACT1

T4-2

GE4-2

C3b ⎱ C3
C3a ⎰

T4-1

GE4-1

T3-1

GE3-1

GE3-2

T3-2

CT6

CT7

T1

CT8

GE6

T6

PCE1

CT3

CT2

T7

GE7

III

II

III'

I

II'

I'

VIL2b  GE8  DL1    PCE2      VDLc      DL3

DR2
⊙ DR3 → DR1

VIL2 : VIL2a, VIL2b
VDL : VDLa, VDLb, VDLc
GBL : GBLa, GBLb

⊠ CTa
⊞ CTb
⊠ CTc

Fig. 17

111, 333

VIL1a(VIL1)

ACT1

C3b ⎫
     ⎬ C3
CN2  ⎪
EX2 ⎫
CCN ⎬ C3a
EX1 ⎭
CN1

VDLa                                    VDLa

RSP

RPL

ACT2

DR2
↑
⊙——→ DR1
DR3

Fig. 18

Fig. 19

ENC { TFE3, TFE2, TFE1
EMTL { CM, EL, PE3
TFTL { VIA2, VIA1, ITL, GTI2, GTI1, BF, BR, SUB

PDL

PE3

VDLc

VDLb

VDLa 40

CT5

ACT1

CT6

40

CT8

CT7

VDLb

VDLa

GE1

II

E311

ACT1

CH1 C1 ACT1

ACT1 E61

II'

Fig. 20

T3-2 : GE3-2, E321, CH3-2, E322
T4-2 : GE4-2, E421, CH4-2, E422

EP 4 604 112 A1

Fig. 21

VBL
VIL1a(VIL1)
GIL
EX2
GWL
CN2
CNN
GCL
DL1
EX1
CN1
GE2
CT5
T2
GE1
VDLa
VDLb
GE5
T5
CT4
CT1
RPL
GBLb
GBLa
VIL2a
T8
ACT2
VBL

I
CT9
ACT1
CCE
T4-2
GE4-2
CT10
C3b
C3
C3a
T4-1
GE4-1
II
T3-1
GE3-1
GE3-2
T3-2
CT6
CT7
T1
CT8
GE6
T6
PCE1
CT3
CT2
T7
GE7

VIL2b GE8 DL1 PCE2 VDLc DL3

DR2

DR1

DR3

VIL2 : VIL2a, VIL2b
VDL : VDLa, VDLb, VDLc
GBL : GBLa, GBLb

⊠ CTa
⊞ CTb
⊠ CTc

Fig. 22

## Fig. 23

Fig. 24

Fig. 25

VIL2 : VIL2a, VIL2b
VDL : VDLa, VDLb, VDLc
GBL : GBLa, GBLb

⊠ CTa
⊞ CTb
⊠ CTc

Fig. 26

VBL
VIL1a(VIL1)
GIL
EX2
GWL
CN2
CNN
GCL
DL1
EX1
CN1
GE2
CT5
T2
GE1
VDLa
VDLb
GE5
T5
CT4
CT1
RPL
GBLb
GBLa
VIL2a
T8
ACT2
VBL

ACT1
T4-2
GE4-2
C3b } C3
C3a }
T4-1
GE4-1
CT14
T3-1
GE3-1
GE3-2
T3-2
CCE
CT6
CT7
T1
CT8
GE6
T6
PCE1
CT3
CT2
T7
GE7
CT13

VIL2b  GE8  DL1  PCE2  VDLc  DL3

DR2
DR3
DR1

VIL2 : VIL2a, VIL2b
VDL : VDLa, VDLb, VDLc
GBL : GBLa, GBLb

⊠ CTa
⊞ CTb
⊠ CTc

Fig. 27

Fig. 28

Fig. 29

Fig. 30

| | |
|---|---|
| | 205 |
| EL1 | EU3 |
| CGL2 | |
| EL2 | EU2 |
| EL3 | |
| CGL1 | |
| EL1 | EU1 |
| | 201 |

203

Fig. 31

| | |
|---|---|
| | 205 |
| EL1 | EU3 |
| CGL2 | |
| EL4 | |
| EL2 | EU2 |
| EL3 | |
| CGL1 | |
| EL1 | EU1 |
| | 201 |

203

Fig. 32

| | |
|---|---|
| | 205 |
| EIL | |
| ETL | EU3 |
| BEML | |
| HTL | |
| pCGL | CGL2 |
| nCGL | |
| ETL | |
| YEML | |
| REML | EU2 |
| HTL | |
| pCGL | CGL1 |
| nCGL | |
| BEML | |
| HIL | EU1 |
| HTL | |
| | 201 |

Fig. 33

| | |
|---|---|
| 205 | |
| EIL | |
| ETL | EU3 |
| BEML | |
| HTL | |
| pCGL | CGL2 |
| nCGL | |
| ETL | |
| GEML | |
| YEML | EU2 |
| REML | |
| HTL | |
| pCGL | CGL1 |
| nCGL | |
| BEML | |
| HIL | EU1 |
| HTL | |
| 201 | |

203

Fig. 34

Fig. 35

| | comparative disclosure | present disclosure |
|---|---|---|
| Avg | -46.6 | -54.7 |
| StdDev | 0.874 | 1.66 |
| Max | -45.6 | -52.7 |

**EP 4 604 112 A1**

<table>
<tr><td colspan="3">**INTERNATIONAL SEARCH REPORT**</td><td>International application No.<br>**PCT/KR2023/008892**</td></tr>
</table>

| A. | CLASSIFICATION OF SUBJECT MATTER |
|---|---|

G09G 3/3233(2016.01)i; H10K 59/121(2023.01)i; H10K 59/131(2023.01)i; H10K 59/80(2023.01)i; G09G 3/20(2006.01)i

According to International Patent Classification (IPC) or to both national classification and IPC

| B. | FIELDS SEARCHED |
|---|---|

Minimum documentation searched (classification system followed by classification symbols)

G09G 3/3233(2016.01); G09G 3/20(2006.01); G09G 3/30(2006.01); G09G 3/32(2006.01); G09G 3/3225(2016.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 트랜지스터(transistor), 공통 노드(common node), 커패시터(capacitor), 유기 발광 표시 장치(organic light emitting display apparatus), 듀얼 게이트(dual gate), 누설 전류(leakage current)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-1794648 B1 (LG DISPLAY CO., LTD.) 08 November 2017 (2017-11-08)<br>See paragraphs [0003], [0026], [0030]-[0033], [0046] and [0056]; claim 1; and figures 1-2 and 4-5c. | 1-8,12-17,22-28 |
| A | | 9-11,18-21 |
| Y | KR 10-0795810 B1 (SAMSUNG SDI CO., LTD.) 21 January 2008 (2008-01-21)<br>See paragraphs [0028], [0050] and [0055]-[0056]; and figures 2 and 4. | 1-8,12-17,22-28 |
| Y | KR 10-2022-0097824 A (SAMSUNG DISPLAY CO., LTD.) 08 July 2022 (2022-07-08)<br>See paragraph [0079]; and figures 5-6. | 13-17 |
| A | KR 10-2011-0079220 A (SAMSUNG MOBILE DISPLAY CO., LTD.) 07 July 2011 (2011-07-07)<br>See paragraphs [0033]-[0075]; and figures 2-7. | 1-28 |
| A | KR 10-2020-0032628 A (SAMSUNG DISPLAY CO., LTD.) 26 March 2020 (2020-03-26)<br>See paragraphs [0057]-[0114]; and figures 4-11. | 1-28 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 September 2023** | **21 September 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/008892**

| Patent document cited in search report | | | Publication date (day/month/year) | Patent family member(s) | | | Publication date (day/month/year) |
|---|---|---|---|---|---|---|---|
| KR | 10-1794648 | B1 | 08 November 2017 | KR 10-2012-0074422 | | A | 06 July 2012 |
| KR | 10-0795810 | B1 | 21 January 2008 | None | | | |
| KR | 10-2022-0097824 | A | 08 July 2022 | CN | 114695488 | A | 01 July 2022 |
| | | | | US | 2022-0208088 | A1 | 30 June 2022 |
| KR | 10-2011-0079220 | A | 07 July 2011 | KR | 10-1097325 | B1 | 23 December 2011 |
| | | | | US | 2011-0157126 | A1 | 30 June 2011 |
| | | | | US | 8547372 | B2 | 01 October 2013 |
| KR | 10-2020-0032628 | A | 26 March 2020 | CN | 110910831 | A | 24 March 2020 |
| | | | | US | 10839757 | B2 | 17 November 2020 |
| | | | | US | 11164533 | B2 | 02 November 2021 |
| | | | | US | 2020-0090595 | A1 | 19 March 2020 |
| | | | | US | 2021-0082353 | A1 | 18 March 2021 |

Form PCT/ISA/210 (patent family annex) (July 2022)